# EUROPÄISCHE PATENTANMELDUNG

(11) **EP 4 726 071 A1**
(43) Veröffentlichungstag der Anmeldung: **15.04.2026**
(21) Anmeldenummer: 25202624.0
(22) Anmeldetag: 17.09.2025
(51) Int. Cl.: C23C 14/34, C23C 14/35, C23C 14/56, H01J 37/34

(54) **PROZESSIERVORRICHTUNG-WECHSELSYSTEM UND VAKUUMANORDNUNG**

(30) Priorität: 20.09.2024 EP 24201643; 12.12.2024 DE 102024137336
(71) Anmelder: VON ARDENNE Asset GmbH & Co. KG, 01328 Dresden (DE)
(72) Erfinder: Siegert, Martin, 01778 Altenberg (DE); Großer, Götz, 01328 Dresden (DE); Flath, Thomas, 01309 Dresden (DE)

(57) **Zusammenfassung**

Gemäß verschiedenen Ausführungsformen weist ein Prozessiervorrichtung-Wechselsystem auf: ein Vakuumkammergehäuse (502), welches eine Transferöffnung (120) aufweist; mehrere in dem Kammergehäuse angeordnete erste Lagersockel, wovon jeder erste Lagersockel eingerichtet ist, eine Prozessiervorrichtung aufzunehmen; eine Transportvorrichtung, welche eingerichtet ist, für jeden der ersten Lagersockel einen Transportpfad zwischen dem ersten Lagersockel und der Transferöffnung (120) bereitzustellen zum Transportieren der Prozessiervorrichtung entlang des Transportpfads.

## Beschreibung

Verschiedene Ausführungsbeispiele betreffen ein Prozessiervorrichtung-Wechselsystem und eine Vakuumanordnung.

Im Allgemeinen kann ein Substrat in einem Vakuum behandelt (prozessiert), z.B. beschichtet werden, so dass die chemischen und/oder physikalischen Eigenschaften des Substrats verändert werden können. Zum Beschichten eines Substrats können verschiedene Beschichtungsverfahren durchgeführt werden, wovon die physikalische Gasphasenabscheidung (PVD) ein etablierter Vertreter ist. Beispielsweise kann eine Vakuumbeschichtungsanlage genutzt werden, um eine Schicht oder mehrere Schichten mittels einer chemischen und/oder physikalischen Gasphasenabscheidung auf einem Substrat oder auf mehreren Substraten abzuscheiden.

Varianten der Vakuumbeschichtungsanlage sind als Durchlaufanlage oder als Stationär-Prozessieranlage, in welcher die Substrate ortsfest prozessiert werden, eingerichtet. Die Stationär-Prozessieranlage wird insbesondere dann eingesetzt, wenn das Substrat, z.B. dessen Geometrie, einen Transport beim Beschichten erschwert. Allerdings ist die Stationär-Prozessieranlage häufig limitiert in ihrem Durchsatz und/oder der Komplexität der herzustellenden Beschichtung, insbesondere da häufig ein Kompromiss zugunsten der Kosten darin besteht, dass nur ein Roboter zum Beschichten verwendet wird, dessen Targetmaterial gewechselt wird.

Gemäß verschiedenen Ausführungsformen wurde anschaulich erkannt, dass eine automatisierte Befestigung des Targets mittels eines Mechanismus an der am Roboter befindlichen Prozessiervorrichtung sowie das Hemmen der Verschmutzung von Kontaktflächen, Target, Prozessiervorrichtung und ggf. thermischer Kontaktfolie an der Prozessiervorrichtung Roboter herausfordernd sind, und daher nur selten hohen Anforderungen genügen.

Gemäß verschiedenen Ausführungsformen werden diese Aspekte adressiert mittels eines Prozessiervorrichtung-Wechselsystems und einer dieses aufweisenden Vakuumanordnung. Anschaulich stellt das Prozessiervorrichtung-Wechselsystem einen automatisierten Wechsel von Targets bereit, so dass eine komplexe und hohe Anforderungen an die Qualität erfüllende Beschichtung möglichst kostengünstig hergestellt werden kann. Unter anderem erleichtert es das Prozessiervorrichtung-Wechselsystems beim Targetwechsel nicht nur das Target, sondern die gesamte Prozessiervorrichtung samt Magnetsystem zu wechseln.

Im Folgenden werden verschiedene Beispiele beschrieben, die sich auf das hierin Beschriebene und in den Figuren Dargestellte beziehen.

Beispiel 1 (z.B. ein Prozessiervorrichtung-Wechselsystem) ist eingerichtet gemäß einem der beigefügten Ansprüche und/oder weist auf: ein Kammergehäuse (z.B. Vakuumkammergehäuse), welches eine Transferöffnung aufweist und/oder eine erste Vakuumkammer bereitstellt; mehrere in dem Kammergehäuse (z.B. in der ersten Vakuumkammer) bereitgestellte (z.B. angeordnete) erste Lagersockel (auch als Aufbewahrungssockel bezeichnet), welche im Wesentlichen gleichartig eingerichtet sind und/oder wovon jeder erste Lagersockel eingerichtet ist, eine Prozessiervorrichtung (z.B. von mehreren Prozessiervorrichtungen) aufzunehmen; eine Transportvorrichtung, welche eingerichtet ist, für jeden der ersten Lagersockel (z.B. pro Lagersockel) einen Transportpfad (z.B. in dem Kammergehäuse, z.B. der ersten Vakuumkammer) zwischen dem ersten Lagersockel und der Transferöffnung bereitzustellen zum Transportieren der Prozessiervorrichtung entlang des Transportpfads. Die mehreren Prozessiervorrichtungen können beispielsweise eine erste und/oder eine zweite Prozessiervorrichtung aufweisen.

Beispiel 2 (z.B. ein Prozessiervorrichtung-Wechselsystem) ist eingerichtet gemäß Beispiel 1, ferner aufweisend: einen Endeffektor, welcher eingerichtet ist, (z.B. vakuumdicht) in der Transferöffnung aufgenommen zu werden und einen zweiten Lagersockel aufweist, der eingerichtet ist, die Prozessiervorrichtung aufzunehmen und/oder an die Transportvorrichtung zu übergeben; wobei der Endeffektor vorzugsweise ein Anschlusssystem (z.B. eine oder mehr als eine Schnellkupplung aufweisend) aufweist, das eingerichtet ist, mit der Prozessiervorrichtung gekuppelt zu werden, wenn (z.B. in Antwort darauf) die Prozessiervorrichtung in dem zweiten Lagersockel aufgenommen ist oder wird, wobei der zweite Lagersockel vorzugsweise eine Montagevorrichtung aufweist.

Beispiel 3 (z.B. ein Prozessiervorrichtung-Wechselsystem) ist eingerichtet gemäß Beispiel 2, wobei das Anschlusssystem eingerichtet ist zum Austauschen von elektrischer Energie und/oder eines (z.B. flüssigen oder gasförmigen) Fluids (z.B. Kühlfluids) mit der Prozessiervorrichtung; und/oder wobei das Anschlusssystem eine oder mehr als eine Schnellkupplung aufweist. Das Fluid kann beispielsweise eine oder mehr als eine Flüssigkeit und/oder einen oder mehr als ein Gas aufweisen oder daraus bestehen.

Beispiel 4 (z.B. ein Prozessiervorrichtung-Wechselsystem) ist eingerichtet gemäß einem der Beispiele 1 bis 3, ferner aufweisend: einen dritten Lagersockel (auch als Transfersockel bezeichnet), welcher in dem Kammergehäuse angeordnet und eingerichtet ist, die Prozessiervorrichtung aufzunehmen; wobei die Transportvorrichtung eingerichtet ist, für jeden der ersten Lagersockel einen zusätzlichen Transportpfad zwischen dem ersten Lagersockel und dem dritten Lagersockel und/oder zwischen der Transferöffnung und dem dritten Lagersockel bereitzustellen zum Transportieren der Prozessiervorrichtung entlang des zusätzlichen Transportpfads; wobei sich der dritte Lagersockel vorzugsweise von dem ersten Lagersockeln unterscheidet, z.B. in einer Dichtvorrichtung, einer Montagevorrichtung und/oder einem Verriegelungsmechanismus.

Beispiel 5 (z.B. ein Prozessiervorrichtung-Wechselsystem) ist eingerichtet gemäß einem der Beispiele 1 bis 4, wobei einer oder mehr als einer (z.B. jeder) der ersten Lagersockel (z.B. dessen Montagevorrichtung) einem Typ der Prozessiervorrichtung zugeordnet ist und eingerichtet ist, (z.B. nur) den Typ der Prozessiervorrichtung aufzunehmen, welche dem Lagersockel zugeordnet ist. Dies hemmt eine Fehlbedienung.

Beispiel 6 (z.B. ein Prozessiervorrichtung-Wechselsystem) ist eingerichtet gemäß einem der Beispiele 1 bis 5, wobei einer oder mehr als einer (z.B. jeder) der ersten Lagersockel (z.B. dessen Montagevorrichtung) einer Geometrie der Prozessiervorrichtung zugeordnet ist und eingerichtet ist, nur die Prozessiervorrichtung der Geometrie aufzunehmen, welche dem Lagersockel zugeordnet ist. Dies hemmt eine Fehlbedienung.

Beispiel 7 (z.B. ein Prozessiervorrichtung-Wechselsystem) ist eingerichtet gemäß einem der Beispiele 1 bis 6, wobei sich die ersten Lagersockel (z.B. deren Montagevorrichtung) voneinander unterscheiden in einem Typ und/oder einer Geometrie der Prozessiervorrichtung, welchem diese zugeordnet sind; wobei der zweite und/oder dritte Lagersockel vorzugsweise eingerichtet sind, Prozessiervorrichtungen voneinander verschiedener Geometrie aufzunehmen. Beispiel 8 (z.B. ein Prozessiervorrichtung-Wechselsystem) ist eingerichtet gemäß einem der Beispiele 1 bis 7, wobei sich die ersten Lagersockel (z.B. deren Montagevorrichtung) voneinander unterscheiden einer Geometrie ihrer Montagevorrichtung.

Beispiel 9 (z.B. ein Prozessiervorrichtung-Wechselsystem) ist eingerichtet gemäß einem der Beispiele 1 bis 8, wobei das Kammergehäuse eine Kammerwand aufweist, mit welcher vorzugsweise jeder der ersten Lagersockel (oder zumindest eine Komponente dessen, z.B. dessen Montagevorrichtung und/oder dessen Dichtvorrichtung) gekuppelt ist und/oder welche vorzugsweise von mehreren Durchgangsöffnungen durchdrungen ist, welche weiter vorzugsweise fluidleitend miteinander gekoppelt sind und/oder wovon jede Durchgangsöffnung einen Aufnahmeraum des ersten Lagersockels bereitstellt und/oder in diesem mündet.

Beispiel 10 (z.B. ein Prozessiervorrichtung-Wechselsystem) ist eingerichtet gemäß einem der Beispiele 1 bis 9, die mehreren ersten Lagersockel in dem Kammergehäuse angeordnet sind und ein zweiter Lagersockel mittels des Endeffektors bereitgestellt ist

Beispiel 11 (z.B. ein Prozessiervorrichtung-Wechselsystem) ist eingerichtet gemäß einem der Beispiele 1 bis 10, wobei ein oder mehr als ein (z.B. jeder der ersten, der zweite und/oder der dritte) Lagersockel eine Dichtvorrichtung aufweist zum vakuumdichten Aufnehmen der Prozessiervorrichtung. Die Dichtvorrichtung kann beispielsweise eingerichtet sein, einen an die Prozessiervorrichtung angrenzenden Spalt abzudichten, welcher an den Aufnahmeraum des Lagersockels und/oder das Inneren des Kammergehäuses angrenzt.

Beispiel 12 (z.B. ein Prozessiervorrichtung-Wechselsystem) ist eingerichtet gemäß einem der Beispiele 1 bis 11, wobei ein oder mehr als ein (z.B. jeder der ersten, der zweite und/oder der dritte) Lagersockel eine Montagevorrichtung (z.B. Kupplungsvorrichtung) zum Montieren (z.B. zum Ankuppeln) der Prozessiervorrichtung daran aufweist, welche vorzugsweise eingerichtet ist, die Prozessiervorrichtung gegen die Dichtvorrichtung zu pressen, vorzugsweise in Antwort darauf, dass die Prozessiervorrichtung relativ zu der Montagevorrichtung bewegt (z.B. gedreht) wird und/oder dass ein Verriegelungsmechanismus betätigt wird.

Beispiel 13 (z.B. ein Prozessiervorrichtung-Wechselsystem) ist eingerichtet gemäß einem der Beispiele 1 bis 12, wobei ein oder mehr als ein (z.B. jeder der ersten, der zweite und/oder der dritte) Lagersockel (z.B. dessen Montagevorrichtung) eingerichtet ist, eine Dreh-Steckverbindung (z.B. einen Bajonettschluss) mit der Prozessiervorrichtung zu implementieren.

Beispiel 14 (z.B. ein Prozessiervorrichtung-Wechselsystem) ist eingerichtet gemäß einem der Beispiele 1 bis 13, ferner eine Betätigungsvorrichtung (z.B. Sockel-Betätigungsvorrichtung) aufweisend (z.B. als Komponente der Transportvorrichtung oder separat davon), welche eingerichtet ist, eine Kupplung der Prozessiervorrichtung mit der Montagevorrichtung eines oder mehr als eines (z.B. jedes der ersten, des zweiten und/oder des dritten) Lagersockels zu arretieren.

Beispiel 15 (z.B. ein Prozessiervorrichtung-Wechselsystem) ist eingerichtet gemäß einem der Beispiele 1 bis 14, wobei die Transportvorrichtung eingerichtet ist, die Prozessiervorrichtung in jeden der ersten Lagersockel hineinzustecken und/oder davon abzuheben; und/oder wobei die Transportvorrichtung (z.B. eine Gabel dieser) eingerichtet ist, in eine Nut (auch als Aufnahmenut bezeichnet) der Prozessiervorrichtung hineinzugreifen.

Beispiel 16 (z.B. ein Prozessiervorrichtung-Wechselsystem) ist eingerichtet gemäß einem der Beispiele 1 bis 15, wobei die Transportvorrichtung einen Aktuator (z.B. Greifer und/oder Greifarm aufweisend) aufweist, der eingerichtet ist, die Prozessiervorrichtung anzukuppeln und/oder relativ zu dem Kammergehäuse zu bewegen (z.B. zu drehen). Beispiel 17 (z.B. ein Prozessiervorrichtung-Wechselsystem) ist eingerichtet gemäß einem der Beispiele 1 bis 16, ferner die Prozessiervorrichtung aufweisend, wobei die Prozessiervorrichtung vorzugsweise als Beschichtungsvorrichtung eingerichtet ist; und/oder wobei die Prozessiervorrichtung ein Magnetsystem und/oder ein Sputtertarget (auch als Target bezeichnet) oder zumindest eine Lagervorrichtung zum Lagern eines Sputtertargets aufweist.

Beispiel 18 (z.B. ein Prozessiervorrichtung-Wechselsystem) ist eingerichtet gemäß einem der Beispiele 1 bis 17, ferner eine Steuervorrichtung aufweisend, welche eingerichtet ist, die Transportvorrichtung gemäß einer (z.B. abgespeicherten) Transportsequenz anzusteuern, wobei die Transportsequenz aufweist: eine erste Phase (auch als erste Transportphase bezeichnet), in welcher eine erste Prozessiervorrichtung mittels der Transportvorrichtung von der Transferöffnung weg (z.B. aus dieser heraus) transportiert (und/oder von dem Endeffektor getrennt wird) wird und/oder in welcher die zweite Prozessiervorrichtung von dem Transfersockel aufgenommen ist; eine zweite Phase (auch als zweite Transportphase bezeichnet), in welcher die zweite Prozessiervorrichtung mittels der Transportvorrichtung zu der Transferöffnung hin (z.B. in diese hinein) transportiert wird (und/oder an den Endeffektor übergeben wird) und/oder in welcher die erste Prozessiervorrichtung von dem Transfersockel aufgenommen ist; wobei die erste Prozessiervorrichtung vorzugsweise zu einem (z.B. ausgewählten Lagersockel) der ersten Lagersockel hin transportiert (z.B. von der Transportvorrichtung an diesen übergeben) wird, von welcher die zweite Prozessiervorrichtung weg transportiert (z.B. von diesem an die Transportvorrichtung übergeben) wird und/oder wobei die erste und die zweite Prozessiervorrichtung vorzugsweise aneinander vorbei transportiert werden.

Beispiel 19 (z.B. ein Verfahren, vorzugsweise zum Betreiben des Prozessiervorrichtung-Wechselsystems gemäß einem der Beispiele 1 bis 18) weist auf: Transportieren einer ersten Prozessiervorrichtung mittels der Transportvorrichtung von einer Transferöffnung weg (z.B. aus dieser heraus), vorzugsweise so dass die erste Prozessiervorrichtung von dem Endeffektor getrennt (z.B. an die Transportvorrichtung übergeben) wird und/oder wenn die zweite Prozessiervorrichtung von dem Transfersockel aufgenommen ist; Transportieren einer zweiten Prozessiervorrichtung mittels der Transportvorrichtung zu der Transferöffnung hin (z.B. in diese hinein), vorzugsweise so dass die zweite Prozessiervorrichtung mit dem Endeffektor zusammengefügt (z.B. an diesen übergeben) wird und/oder wenn die erste Prozessiervorrichtung von dem Transfersockel aufgenommen ist; wobei die erste Prozessiervorrichtung vorzugsweise zu einem (z.B. ausgewählten Lagersockel) der ersten Lagersockel hin transportiert (z.B. von der Transportvorrichtung an diesen übergeben) wird, von welcher die zweite Prozessiervorrichtung weg transportiert (z.B. an die Transportvorrichtung übergeben) wird, und/oder wobei die erste und die zweite Prozessiervorrichtung vorzugsweise aneinander vorbei transportiert werden.

Beispiel 20 ist ein Computerprogramm, das eingerichtet ist, wenn von einem Prozessor ausgeführt, den Prozessor dazu zu bringen, das Prozessiervorrichtung-Wechselsystem (z.B. ein oder mehr als ein Stellglied dessen) anzusteuern zum Durchführen des Verfahrens gemäß Beispiel 19.

Beispiel 21 ist ein computerlesbares Medium, das Instruktionen speichert, die eingerichtet sind, wenn von einem Prozessor ausgeführt, den Prozessor dazu zu bringen, das Prozessiervorrichtung-Wechselsystem (z.B. ein oder mehr als ein Stellglied dessen) anzusteuern zum Durchführen des Verfahrens gemäß Beispiel 19.

Beispiel 22 ist eine Steuervorrichtung, welche einen oder mehr als einen Prozessor aufweist, der eingerichtet ist, das Prozessiervorrichtung-Wechselsystem (z.B. ein oder mehr als ein Stellglied dessen) anzusteuern zum Durchführen des Verfahrens gemäß Beispiel 19.

Beispiel 23 (z.B. eine Vakuumanordnung) ist eingerichtet gemäß einem der beigefügten Ansprüche und/oder weist auf: ein Prozessiervorrichtung-Wechselsystem gemäß einem der Beispiele 1 bis 18; eine (z.B. mittels des Kammergehäuses bereitgestellte) Prozessierkammer, in welcher die Transferöffnung mündet; eine Substrathaltevorrichtung zum Halten eines (z.B. unebenen) Substrats in der Prozessierkammer; einen Roboter (z.B. eingerichtet, mit dem Endeffektor gekuppelt zu werden), wobei der Roboter in der Prozessierkammer angeordnet und/oder eingerichtet ist, die Prozessiervorrichtung (z.B. mittels der Transferöffnung) an die Transportvorrichtung zu übergeben und/oder von dieser übergeben zu bekommen. Vorzugsweise kann der Roboter eingerichtet sein, die Prozessiervorrichtung zu der Transferöffnung hin (z.B. in die Transferöffnung hinein) und/oder von dieser weg (z.B. aus dieser heraus) zu bewegen und/oder die Prozessiervorrichtung in der Prozessierkammer zu bewegen, vorzugsweise gemäß einem (z.B. abgespeicherten) Bewegungsschema, das vorzugsweise eine Funktion des Substrats (z.B. dessen Geometrie) ist und/oder zu dieser komplementär ist.

Beispiel 24 (z.B. eine Vakuumanordnung) ist eingerichtet gemäß Beispiel 23, ferner die Steuervorrichtung oder eine zusätzliche Steuervorrichtung aufweisend, welche eingerichtet ist, den Roboter gemäß einer (z.B. abgespeicherten) Beschichtungssequenz anzusteuern, wobei die Beschichtungssequenz aufweist: eine erste Phase (auch als erste Beschichtungsphase bezeichnet), in welcher eine erste Prozessiervorrichtung mittels des Roboters (und/oder in der Prozessierkammer) von der Transferöffnung weg (z.B. aus der Transferöffnung heraus) transportiert wird und/oder das Substrat mittels der ersten Prozessiervorrichtung prozessiert (z.B. beschichtet) wird; eine zweite Phase (auch als zweite Beschichtungsphase bezeichnet), in welcher eine zweite Prozessiervorrichtung mittels des Roboters (und/oder in der Prozessierkammer) von der Transferöffnung weg (z.B. aus der Transferöffnung heraus) transportiert wird und/oder das Substrat mittels der zweiten Prozessiervorrichtung prozessiert (z.B. beschichtet) wird; wobei die erste Prozessiervorrichtung vorzugsweise (z.B. zu Beginn der ersten Phase) von der Transportvorrichtung an den Roboter (z.B. dessen Endeffektor) und/oder (z.B. zum Ende der ersten Phase) von dem Roboter an die Transportvorrichtung übergeben wird; und/oder wobei die zweite Prozessiervorrichtung vorzugsweise (z.B. zu Beginn der zweiten Phase) von der Transportvorrichtung an den Roboter (z.B. dessen Endeffektor) und/oder (z.B. zum Ende der zweiten Phase) von dem Roboter an die Transportvorrichtung übergeben wird.

Beispiel 25 (z.B. ein Verfahren, vorzugweise zum Betreiben der Vakuumanordnung gemäß einem der Beispiele 20 bis 24) weist auf: Transportieren der ersten Prozessiervorrichtung mittels des Roboters (und/oder in der Prozessierkammer) von der Transferöffnung weg (z.B. aus der Transferöffnung heraus) und/oder Prozessieren (z.B. Beschichten) des Substrats mittels der ersten Prozessiervorrichtung; Transportieren der zweiten Prozessiervorrichtung mittels der Transportvorrichtung (und/oder in der Prozessierkammer) von der Transferöffnung weg und/oder Prozessieren (z.B. Beschichten) des Substrats mittels der zweiten Prozessiervorrichtung; wobei die erste Prozessiervorrichtung vorzugsweise (z.B. zu Beginn der ersten Phase) von der Transportvorrichtung an den Roboter (z.B. dessen Endeffektor) und/oder (z.B. zum Ende der ersten Phase) von dem Roboter an die Transportvorrichtung übergeben wird; und/oder wobei die zweite Prozessiervorrichtung vorzugsweise (z.B. zu Beginn der zweiten Phase) von der Transportvorrichtung an den Roboter (z.B. dessen Endeffektor) und/oder (z.B. zum Ende der zweiten Phase) von dem Roboter an die Transportvorrichtung übergeben wird.

Beispiel 26 ist ein Computerprogramm, das eingerichtet ist, wenn von einem Prozessor ausgeführt, den Prozessor dazu zu bringen, die Vakuumanordnung (z.B. ein oder mehr als ein Stellglied dessen) anzusteuern zum Durchführen des Verfahrens gemäß Beispiel 25.

Beispiel 27 ist ein computerlesbares Medium, das Instruktionen speichert, die eingerichtet sind, wenn von einem Prozessor ausgeführt, den Prozessor dazu zu bringen, die Vakuumanordnung (z.B. ein oder mehr als ein Stellglied dessen) anzusteuern zum Durchführen des Verfahrens gemäß Beispiel 25.

Beispiel 28 ist eine Steuervorrichtung, welche einen oder mehr als einen Prozessor aufweist, der eingerichtet ist, die Vakuumanordnung (z.B. ein oder mehr als ein Stellglied dessen) anzusteuern zum Durchführen des Verfahrens gemäß Beispiel 25.

Beispiel 29 ist eingerichtet gemäß einem der Beispiele 1 bis 28, wobei der Endeffektor den zweiten Lagersockel, der eingerichtet ist, die Prozessiervorrichtung aufzunehmen; und/oder (wobei z.B. der zweite Lagersockel) eine Montagevorrichtung zum Montieren der Prozessiervorrichtung aufweist, welche vorzugsweise eingerichtet ist, die Prozessiervorrichtung gegen eine Aufnahmefläche (z.B. einer Dichtvorrichtung) des Endeffektors (z.B. zweiten Lagersockels) zu pressen, vorzugsweise in Antwort darauf, dass die Prozessiervorrichtung relativ zu der Montagevorrichtung bewegt (z.B. gedreht) wird und/oder dass ein Verriegelungsmechanismus betätigt wird.

Beispiel 30 ist eingerichtet gemäß einem der Beispiele 1 bis 29, ferner aufweisend: mehrere Prozessiervorrichtungen, welche sich voneinander unterscheiden in einem Sputtertarget (z.B. dessen chemischer Zusammensetzung) und/oder einem Magnetsystem (z.B. dessen Konfiguration), wovon vorzugsweise jede Prozessiervorrichtung eingerichtet ist, von dem zweiten und/oder dem dritten Lagersockel und/oder zumindest einem (d.h. einem oder mehr als einem) der ersten Lagersockel aufgenommen zu werden, z.B. von zumindest einem der ersten Lagersockel, welcher einem Typ (z.B. einer Geometrie und/oder Indikator) der Prozessiervorrichtung zugeordnet ist.

Beispiel 31 ist eingerichtet gemäß einem der Beispiele 1 bis 30, wobei einer oder mehr als einer (z.B. jeder) der ersten Lagersockel eingerichtet ist, einen ersten Verriegelungsmechanismus zu implementieren, welcher, in einen verriegelnden Zustand gebracht, die Prozessiervorrichtung mit dem Vakuumkammergehäuse (oder zumindest dem Lagersockel) arretiert, wobei vorzugsweise eine erste Betätigungsvorrichtung (auch als Sockel-Betätigungsvorrichtung bezeichnet) in dem Kammergehäuse angeordnet ist, welche eingerichtet ist, den ersten Verriegelungsmechanismus in den verriegelnden Zustand zu bringen oder aus dem verriegelnden Zustand heraus zu bringen (z.B. in einen unverriegelnden Zustand, in dem die Arretierung aufgehoben ist).

Beispiel 32 ist eingerichtet gemäß einem der Beispiele 1 bis 31, wobei der zweite Lagersockel eingerichtet ist, einen zweiten Verriegelungsmechanismus zu implementieren, welcher, in einen verriegelnden Zustand gebracht, die Prozessiervorrichtung mit dem Endeffektor arretiert, wobei vorzugsweise die erste Betätigungsvorrichtung und/oder eine zweite Betätigungsvorrichtung in dem Kammergehäuse angeordnet ist, welche eingerichtet ist, den zweiten Verriegelungsmechanismus in den verriegelnden Zustand zu bringen oder aus dem verriegelnden Zustand heraus zu bringen (z.B. in einem unverriegelnden Zustand, in dem die Arretierung aufgehoben ist).

Beispiel 33 (z.B. ein Prozessiervorrichtung-Wechselsystem) ist eingerichtet gemäß einem der Beispiele 1 bis 32, wobei eine (z.B. an die Transferöffnung angrenzende und/oder diese umgebende) Montagevorrichtung (auch als Transfer-Montagevorrichtung bezeichnet) eingerichtet ist, einen dritten Verriegelungsmechanismus zu implementieren, welcher, in einen verriegelnden Zustand gebracht, den (z.B. in der Transferöffnung angeordneten) Endeffektor mit dem Kammergehäuse arretiert, wobei vorzugsweise eine dritte Betätigungsvorrichtung (auch als Transfer-Betätigungsvorrichtung bezeichnet) in dem Kammergehäuse angeordnet ist, welche eingerichtet ist den dritten Verriegelungsmechanismus in den verriegelnden Zustand zu bringen oder aus dem verriegelnden Zustand heraus zu bringen (z.B. in einen unverriegelnden Zustand).

Beispiel 34 ist eingerichtet gemäß einem der Beispiele 1 bis 33, ferner aufweisend: eine erste Antriebsvorrichtung, welche mit der Transportvorrichtung gekuppelt ist und/oder eingerichtet ist, der Transportvorrichtung mechanische (z.B. kinetische) Energie zuzuführen; und/oder ein Arretierungsmechanismus, welcher eingerichtet ist, den in der Transferöffnung aufgenommen Endeffektor und das Kammergehäuse miteinander zu arretieren.

Beispiel 35 ist eingerichtet gemäß einem der Beispiele 1 bis 34, ferner aufweisend: für jede (z.B. der ersten, der zweite und/oder der dritte) Betätigungsvorrichtung, eine zweite Antriebsvorrichtung, welche mit der Betätigungsvorrichtung gekuppelt ist und/oder eingerichtet ist, der Betätigungsvorrichtung mechanische (z.B. kinetische) Energie zuzuführen.

Beispiel 36 (z.B. ein Prozessiervorrichtung-Wechselsystem) ist eingerichtet gemäß einem der Beispiele 1 bis 35, wobei der Roboter eine kinematische Kette (z.B. mittels eines Roboterarms bereitgestellt) mit mehreren Gelenken aufweist, welche eingerichtet ist, dem Endeffektor mehr als 3 (z.B. 4, 5 oder 6) Freiheitsgrade bereitzustellen. Beispiele für die Freiheitsgrade weisen auf: zwei oder drei Translationsfreiheitsgrade und/oder einen oder mehr als einen Rotationsfreiheitsgrad, z.B. zwei oder mehr Rotationsfreiheitsgrade. Die kinematische Kette kuppelt beispielsweise eine Montagevorrichtung des Roboters, an welcher der Endeffektor montiert sein oder werden kann, mit dem Kammergehäuse.

Beispiel 37 (z.B. ein Prozessiervorrichtung-Wechselsystem) ist eingerichtet gemäß einem der Beispiele 1 bis 36, wobei die Transferöffnung eine Kammerwand (auch als Transferwand bezeichnet) des Kammergehäuses durchdringt.

Beispiel 38 (z.B. ein Prozessiervorrichtung-Wechselsystem) ist eingerichtet gemäß einem der Beispiele 1 bis 37, ferner eine Dichtvorrichtung (z.B. Dichtfläche) aufweisend, welche: an die Transferöffnung angrenzt und/oder diese umgibt, zumindest eine Dichtnut in der Kammerwand aufweist und/oder entlang eines in sich geschlossenen Pfades um die Transferöffnung herum erstreckt ist, wobei die Dichtvorrichtung vorzugsweise an dem Endeffektor anliegt, wenn dieser in der Transferöffnung angeordnet ist.

Beispiel 39 (z.B. ein Prozessiervorrichtung-Wechselsystem) ist eingerichtet gemäß einem der Beispiele 1 bis 38, wobei einer oder mehr als einer (z.B. jeder) der ersten Lagersockel (z.B. dessen Montagevorrichtung) komplementär zu der Prozessiervorrichtung eingerichtet ist.

Beispiel 40 (z.B. ein Prozessiervorrichtung-Wechselsystem) ist eingerichtet gemäß einem der Beispiele 1 bis 39, wobei der zweite Lagersockel (z.B. dessen Montagevorrichtung) komplementär zu der Prozessiervorrichtung eingerichtet ist.

Beispiel 41 (z.B. ein Prozessiervorrichtung-Wechselsystem) ist eingerichtet gemäß einem der Beispiele 1 bis 40, wobei der dritte Lagersockel komplementär zu der Prozessiervorrichtung eingerichtet ist.

Beispiel 42 (z.B. ein Prozessiervorrichtung-Wechselsystem) ist eingerichtet gemäß einem der Beispiele 1 bis 41, wobei das Kammergehäuse eine oder mehr als eine Vakuumkammer (z.B. erste Vakuumkammer und/oder zweite Vakuumkammer) bereitstellt und/oder eingerichtet ist, ein Vakuum bereitzustellen, wobei vorzugsweise jeder erste Lagersockel und/oder der dritte Lagersockel in der ersten Vakuumkammer bereitgestellt sind und/oder wobei die Transferöffnung in der ersten Vakuumkammer (und/oder in der zweiten Vakuumkammer) mündet.

Beispiel 43 (z.B. ein Prozessiervorrichtung-Wechselsystem) ist eingerichtet gemäß einem der Beispiele 1 bis 42, wobei das Kammergehäuse (z.B. pro Vakuumkammer, z.B. für die Wechselkammer und/oder die Prozessierkammer) einen oder mehr als einen Pumpenanschluss (z.B. Anschlussflansch) aufweist, welcher in der Vakuumkammer mündet, zum Anschließen einer Hochvakuumpumpe und/oder mittels welchem die Hochvakuumpumpe mit der Vakuumkammer fluidleitend gekoppelt ist. Beispielsweise kann ferner die Hochvakuumpumpe vorhanden sein.

Beispiel 44 (z.B. ein Prozessiervorrichtung-Wechselsystem) ist eingerichtet gemäß einem der Beispiele 1 bis 43, wobei die ersten Lagersockel mindestens drei (z.B. vier oder mehr, z.B. fünf oder mehr) Lagersockel aufweisen. Beispiel 45 (z.B. ein Prozessiervorrichtung-Wechselsystem) ist eingerichtet gemäß einem der Beispiele 1 bis 44, ferner aufweisend: eine Montagevorrichtung (z.B. Kupplungsvorrichtung), welche eingerichtet ist, den in der Transferöffnung aufgenommenen Endeffektor anzukuppeln, z.B. derart, dass der Endeffektor und das Kammergehäuse gegeneinander gepresst werden und/oder diese miteinander arretiert werden.

Beispiel 46 (z.B. ein Prozessiervorrichtung-Wechselsystem) ist eingerichtet gemäß einem der Beispiele 1 bis 45, wobei die Transportvorrichtung eingerichtet ist, die Prozessiervorrichtung an jeden der ersten Lagersockel und/oder an den zweiten Lagersockel und/oder an den dritten Lagersockel zu übergeben.

Beispiel 47 (z.B. ein Prozessiervorrichtung-Wechselsystem) ist eingerichtet gemäß einem der Beispiele 1 bis 46, wobei die Transportvorrichtung eingerichtet ist, die Prozessiervorrichtung von jedem der ersten Lagersockel und/oder von dem zweiten Lagersockel und/oder von dem dritten Lagersockel aufzunehmen (übergeben zu bekommen).

Beispiel 48 (z.B. ein Prozessiervorrichtung-Wechselsystem) ist eingerichtet gemäß einem der Beispiele 1 bis 47, wobei einem oder mehr als einem (z.B. jedem) Lagersockel (z.B. der ersten, dem zweiten und/oder dem dritten Lagersockel) eine Übergabeposition der Transportvorrichtung zugeordnet ist, in welcher, wenn die Transportvorrichtung in der Übergabeposition ist, die Transportvorrichtung eingerichtet ist, die Prozessiervorrichtung an den Lagersockel zu übergeben und/oder von dem Lagersockel aufzunehmen (übergeben zu bekommen). Beispiel 49 (z.B. ein Prozessiervorrichtung-Wechselsystem) ist eingerichtet gemäß einem der Beispiele 1 bis 48, wobei einer oder mehr als einer (z.B. jeder) der ersten Lagersockel eingerichtet ist, die Prozessiervorrichtung an die Transportvorrichtung zu übergeben, beispielsweise wenn die Transportvorrichtung in der dem ersten Lagersockel zugeordneten Übergabeposition ist.

Beispiel 50 (z.B. ein Prozessiervorrichtung-Wechselsystem) ist eingerichtet gemäß einem der Beispiele 1 bis 49, wobei der zweite Lagersockel eingerichtet ist, die Prozessiervorrichtung an die Transportvorrichtung zu übergeben, beispielsweise wenn die Transportvorrichtung in der dem zweiten Lagersockel und/oder der Transferöffnung zugeordneten Übergabeposition ist.

Beispiel 51 (z.B. ein Prozessiervorrichtung-Wechselsystem) ist eingerichtet gemäß einem der Beispiele 1 bis 50, wobei der dritte Lagersockel eingerichtet ist, die Prozessiervorrichtung an die Transportvorrichtung zu übergeben, beispielsweise wenn die Transportvorrichtung in der dem dritte Lagersockel zugeordneten Übergabeposition ist. Beispiel 52 (z.B. ein Prozessiervorrichtung-Wechselsystem) ist eingerichtet gemäß einem der Beispiele 1 bis 51, wobei der zweite und/oder dritte Lagersockel eingerichtet sind, Prozessiervorrichtungen voneinander verschieden Typs (z.B. voneinander verschiedener Geometrie) aufzunehmen, welche beispielsweise eine Prozessiervorrichtung ersten Typs aufweisen, welche nur von einem der ersten Lagersockel aufgenommen werden kann, und eine Prozessiervorrichtung zweiten Typs aufweisen, welche nur von einem anderen der ersten Lagersockel aufgenommen werden kann.

Beispiel 53 (z.B. ein Prozessiervorrichtung-Wechselsystem) ist eingerichtet gemäß einem der Beispiele 1 bis 52, wobei die Montagevorrichtung eines oder mehr als eines (z.B. jedes) der ersten Lagersockel und/oder des zweiten Lagersockels rohrförmig ist und/oder einen Aufnahmeraum des Lagersockels entlang eines in sich geschlossenen Pfades umgibt.

Beispiel 54 (z.B. ein Prozessiervorrichtung-Wechselsystem) ist eingerichtet gemäß einem der Beispiele 1 bis 53, wobei die Montagevorrichtung eines oder mehr als eines (z.B. jedes) der ersten Lagersockel und/oder des zweiten Lagersockels eine (z.B. nutförmige) Aussparung aufweist, welche eingerichtet ist, einen (z.B. ringförmigen) Vorsprung der Prozessiervorrichtung aufzunehmen, z.B. zum Bilden eines Formschlusses zwischen der Montagevorrichtung und der Prozessiervorrichtung zum Implementieren eines Bajonettverschlusses.

Beispiel 55 (z.B. ein Prozessiervorrichtung-Wechselsystem) ist eingerichtet gemäß einem der Beispiele 1 bis 54, wobei jeder der ersten Lagersockel und/oder der zweite Lagersockel einen Hohlraum (z.B. eine Vertiefung bereitstellend) und Anschlusssystem aufweist, das in dem Hohlraum angeordnet und eingerichtet ist, mit der Prozessiervorrichtung gekuppelt zu werden, wenn die Prozessiervorrichtung in dem Lagersockel aufgenommen wird. Beispiel 55 (z.B. ein Prozessiervorrichtung-Wechselsystem) ist eingerichtet gemäß einem der Beispiele 1 bis 54, wobei jeder der ersten Lagersockel und/oder der zweite Lagersockel eine unebene Kontur aufweist und/oder eingerichtet zum formschlüssigen Aufnehmen der Prozessiervorrichtung.

Es zeigen
Figur 1A und B jeweils ein Prozessiervorrichtung-Wechselsystem gemäß verschiedenen Ausführungsformen in verschiedenen schematischen Ansichten;
Figur 2A und B jeweils ein Prozessiervorrichtung-Wechselsystem gemäß verschiedenen Ausführungsformen in verschiedenen schematischen Ansichten;
Figur 3A ein Prozessiervorrichtung-Wechselsystem gemäß verschiedenen Ausführungsformen in einer schematischen geschnittenen Detailansicht;
Figur 3B eine Vakuumanordnung gemäß verschiedenen Ausführungsformen in einem schematischen Aufbaudiagramm;
Figur 4A eine Vakuumanordnung gemäß verschiedenen Ausführungsformen in einer schematischen geschnittenen Perspektivansicht; und
Figur 4B ein Verfahren gemäß verschiedenen Ausführungsformen in einem schematischen Ablaufdiagramm.

In der folgenden ausführlichen Beschreibung wird auf die beigefügten Zeichnungen Bezug genommen, die Teil dieser bilden und in denen zur Veranschaulichung spezifische Ausführungsformen gezeigt sind, in denen die Erfindung ausgeübt werden kann. In dieser Hinsicht wird Richtungsterminologie wie etwa "oben", "unten", "vorne", "hinten", "vorderes", "hinteres", usw. mit Bezug auf die Orientierung der beschriebenen Figur(en) verwendet. Da Komponenten von Ausführungsformen in einer Anzahl verschiedener Orientierungen positioniert werden können, dient die Richtungsterminologie zur Veranschaulichung und ist auf keinerlei Weise einschränkend. Es versteht sich, dass andere Ausführungsformen benutzt und strukturelle oder logische Änderungen vorgenommen werden können, ohne von dem Schutzumfang der vorliegenden Erfindung abzuweichen. Es versteht sich, dass die Merkmale der hierin beschriebenen verschiedenen beispielhaften Ausführungsformen miteinander kombiniert werden können, sofern nicht spezifisch anders angegeben. Die folgende ausführliche Beschreibung ist deshalb nicht in einschränkendem Sinne aufzufassen, und der Schutzumfang der vorliegenden Erfindung wird durch die angefügten Ansprüche definiert.

Im Rahmen dieser Beschreibung werden die Begriffe "verbunden", "angeschlossen" sowie "gekoppelt" verwendet zum Beschreiben sowohl einer direkten als auch einer indirekten Verbindung (z.B. elektrisch leitfähigen und/oder fluidleitfähigen Verbindung), eines direkten oder indirekten Anschlusses sowie einer direkten oder indirekten Kopplung. In den Figuren werden identische oder ähnliche Elemente mit identischen Bezugszeichen versehen, soweit dies zweckmäßig ist. Gemäß verschiedenen Ausführungsformen kann der Begriff "gekoppelt" oder "Kopplung" im Sinne einer (z.B. mechanischen, hydrostatischen, thermischen und/oder elektrischen), z.B. direkten oder indirekten, Verbindung und/oder Wechselwirkung verstanden werden. Mehrere Elemente können beispielsweise entlang einer Wechselwirkungskette miteinander gekoppelt sein, entlang welcher die Wechselwirkung ausgetauscht werden kann, z.B. ein Fluid (dann auch als fluidleitend gekoppelt bezeichnet) und/oder Leistung. Beispielsweise können zwei miteinander gekoppelte Elemente eine Wechselwirkung miteinander austauschen, z.B. eine mechanische, hydrostatische, thermische und/oder elektrische Wechselwirkung. Eine Kopplung mehrerer Vakuumkomponenten (z.B. Ventilen, Pumpen, Kammern, usw.) miteinander kann aufweisen, dass diese fluidleitend miteinander gekoppelt sind. Gemäß verschiedenen Ausführungsformen kann "gekuppelt" im Sinne einer mechanischen (z.B. körperlichen) Kopplung verstanden werden, z.B. mittels eines direkten körperlichen Kontakts. Eine Kupplung kann eingerichtet sein, eine mechanische Wechselwirkung (z.B. Kraft, Drehmoment, etc.) zu übertragen. Eine Arretierung (auch als Verriegelung bezeichnet) von zwei miteinander gekuppelten Bauteilen kann die Relativbewegung der zwei Bauteile zueinander, mittels welcher diese aneinander gekuppelt (z.B. ineinander greifend) werden, (z.B. formschlüssig) blockieren. Die Arretierung kann beispielsweise jeden Freiheitsgrad und/oder jede Relativbewegung der zwei Bauteile zueinander (z.B. formschlüssig) blockieren. Die Arretierung kann die zwei Bauteile beispielsweise starr miteinander verbinden und/oder gegeneinander pressen. Wird die Arretierung aufgehoben (auch als Lösen der Arretierung bezeichnet), können die Bauteile wieder voneinander gelöst werden. Die Arretierung kann mittels eines sogenannten Verriegelungsmechanismus implementiert werden. Ein Bauteil (z.B. eine Montagevorrichtung), welches einen Verriegelungsmechanismus implementiert, wird auch als verriegelbares Bauteil bezeichnet.

Als Lagersockel (auch als Lagerfassung bezeichnet) wird hierin eine Vorrichtung zum Halten eines Bauteils (z.B. einer Prozessiervorrichtung) verstanden, welche beispielsweise eingerichtet ist, ein auswechselbares Bauteil schnell daran befestigen und/oder davon lösen zu können. Der Lagersockel und das Bauteil sind beispielsweise zum (beispielsweise formschlüssigen) Ineinandergreifen eingerichtet, so dass diese z.B. formschlüssig aneinander befestigt werden können. Exemplarische Komponenten des Lagersockels weisen auf: eine Dichtvorrichtung (auch als Sockeldichtung bezeichnet), eine Aufnahmefläche, einen Aufnahmeraum (z.B. eine Vertiefung) und/oder eine Montagevorrichtung (z.B. Kupplungsvorrichtung). Eine exemplarische Implementierung des Lagersockels weist eine verriegelbare Montagevorrichtung (z.B. ein Bajonettverschluss implementierend) auf, welche beispielsweise eingerichtet ist, mittels einer Relativbewegung zwischen Bauteil und Lagersockel eine formschlüssige Verbindung zwischen Bauteil und Lagersockel herzustellen und/oder die formschlüssige Verbindung zu arretieren (z.B. mittels einer Betätigungsvorrichtung).

Die hierin bereitgestellten Lagersockel werden zur vereinfachten Unterscheidung gemäß ihren Funktionen und/oder ihrer Position voneinander unterschieden. Ein Lagersockel vom Typ des Montagesockels (vereinfach auch als Montagesockels bezeichnet) weist die Montagevorrichtung (z.B. Kupplungsvorrichtung) auf. Ein Lagersockel vom Typ des Kammersockels (vereinfach auch als Kammersockel bezeichnet) ist ortsfest relativ zu dem Kammergehäuse und/oder in der Wechselkammer angeordnet.

Gemäß verschiedenen Ausführungsformen kann eine Lagervorrichtung zum Lagern (z.B. geführten Positionieren und/oder Halten) eines oder mehr als eines Bauteils eingerichtet sein. Beispielsweise kann die Lagervorrichtung, zum Beispiel pro Bauteil, ein oder mehr als ein Lager aufweisen zum Lagern (z.B. geführten Positionieren und/oder Halten) des Bauteils. Jedes Lager der Ladevorrichtung kann eingerichtet sein, dem Bauteil einen oder mehr als einen Freiheitsgrad (beispielsweise Translationsfreiheitsgrad oder Rotationsfreiheitsgrad) bereitzustellen, gemäß welchem das Bauteil bewegt werden kann. Beispiele für ein Lager weisen auf: Radiallager, Axiallager, Radiaxlager, Linearlager (auch als Linearführung bezeichnet). Pro Linearlager kann dem Bauteil beispielsweise genau einen Translationsfreiheitsgrad bereitgestellt sein.

Als Montagevorrichtung wird hierin eine Vorrichtung verstanden, welche zum Montieren eingerichtet ist, beispielsweise zum Montieren an einer dazu komplementären Montagevorrichtung (auch als Gegen-Montagevorrichtung bezeichnet). Beim Montieren erfolgt ein (z.B. starres) Verbinden mehrerer Komponenten miteinander mittels ihrer Montagevorrichtungen. Das Montieren kann (beispielsweise ausschließlich) formschlüssig und/oder lösbar erfolgen. Die Montagevorrichtung kann vorzugsweise eine (z.B. planare) Montagefläche (z.B. die Aufnahmefläche bereitstellend) aufweisen, welche beim Montieren an einer dazu komplementären Montagefläche der Gegen-Montagevorrichtung anliegt.

Die Montagevorrichtung kann beispielsweise ein oder mehr als ein (z.B. integrales) Montageprofil (z.B. Formschlussprofil) aufweisen, welches beispielsweise mittels einer Unebenheit (z.B. Vorsprung oder Vertiefung) der Montagevorrichtung bereitgestellt ist. Beispiele für das Montageprofil weisen auf: ein Gewinde, eine Nut (z.B. zur Passfederaufnahme und/oder Schwalbenschwanznut), eine Rastnase, ein Bajonettverschluss, ein Zapfen, usw. Beispiele für die Unebenheit weisen auf: eine Öffnung (z.B. Durchgangsöffnung und/oder Gewindebohrung), ein Bolzen (z.B. ein Gewindebolzen). Als Zapfen wird hierin ein (beispielsweise zylindrischer oder quaderförmiger) Fortsatz eines Bauteils verstanden, der eingerichtet ist, dieses mit einem anderen Bauteil zu verbinden. Beispielsweise kann der Zapfen als abgesetzter Endabschnitt bereitgestellt werden. Das zum Zapfen komplementäre kann beispielsweise einen (z.B. nutförmigen) Spalt aufweisen, in welchen der Zapfen (z.B. reibschlüssig) passt. In dem Fall kann der Zapfen auch als Spundung (auch als Spund bezeichnet) bezeichnet werden, insbesondere wenn dieser ein dazu komplementäres Spundloch verschließt.

Gemäß verschiedenen Ausführungsformen kann eine Vakuumkammer mittels eines Kammergehäuses bereitgestellt sein oder werden, in dem eine Kammer oder mehrere Kammern bereitgestellt sein oder werden können. Das Kammergehäuse kann beispielsweise zum Bereitstellen eines Unterdrucks oder eines Vakuums (Vakuumkammergehäuse) mit einer Pumpenanordnung, z.B. einer Vakuumpumpenanordnung, (z.B. gasleitend) gekoppelt sein und derart stabil eingerichtet sein, dass diese dem Einwirken des Luftdrucks im abgepumpten Zustand standhält. Die Pumpenanordnung (aufweisend zumindest eine Vakuumpumpe, z.B. eine Hochvakuumpumpe, z.B. eine Turbomolekularpumpe) kann es ermöglichen, einen Teil des Gases aus dem Inneren der Prozessierkammer, z.B. aus dem Prozessierraum, abzupumpen. Dementsprechend kann eine Vakuumkammer oder können mehrere Vakuumkammern in einem Kammergehäuse bereitgestellt sein. Mit anderen Worten kann das Kammergehäuse als Vakuumkammergehäuse eingerichtet sein bzw. kann eine Beschichtungskammer als eine Vakuumkammer eingerichtet sein.

Der Begriff "Vakuumdruck" bezeichnet hierin einen Unterdruck im Bereich des Vakuums (d.h. ein Druck von weniger als 0,3 bar), z.B. ein Druck in einem Bereich von ungefähr 10 mbar bis ungefähr 1 mbar (mit anderen Worten Grobvakuum) bereitgestellt werden kann oder weniger, z.B. ein Druck in einem Bereich von ungefähr 1 mbar bis ungefähr 10⁻³ mbar (mit anderen Worten Feinvakuum) oder weniger, z.B. ein Druck in einem Bereich von ungefähr 10⁻³ mbar bis ungefähr 10⁻⁷ mbar (mit anderen Worten Hochvakuum) oder weniger, z.B. ein Druck von kleiner als Hochvakuum, z.B. kleiner als ungefähr 10⁻⁷ mbar.

Eine Antriebsvorrichtung kann hierin als Wandler verstanden werden, welcher eingerichtet ist, elektrische Energie in mechanische Energie umzuwandeln. Eine Antriebsvorrichtung kann beispielsweise einen elektrischen Motor (z.B. mit elektrischen Spulen) aufweisen. Eine Antriebsvorrichtung kann beispielsweise einen Kompressor und einen damit gekoppelten Hubkolben aufweisen. Eine Antriebsvorrichtung kann beispielsweise ein oder mehr als ein Piezoelement aufweisen. Beispielsweise kann die Antriebsvorrichtung eingerichtet sein, die mechanische Energie mittels eines Drehmoments bzw. einer Drehbewegung auszugeben.

Der Begriff "Prozessiervorrichtung" bezeichnet hierin eine Vorrichtung, welche zum Prozessieren eines Substrats eingerichtet ist. Beispiele der Prozessiervorrichtung und/oder des Prozessierens sind eingerichtet, das Substrat (z.B. geometrisch, chemisch und/oder physikalisch) zu verändern, zu beschichten, zu reinigen, zu ätzen, usw. Beispiele des Prozessierens sind additiv (d.h. bringen ein Material auf) und/oder subtraktive (d.h. entfernen Material). Beispiele der Prozessiervorrichtung weisen auf: eine Heizvorrichtung, eine Beschichtungsvorrichtung, eine Ätzvorrichtung, usw.

Hierin wird auf eine Beschichtungsvorrichtung als exemplarische Prozessiervorrichtung Bezug genommen, wobei das hierfür Beschriebene in Analogie gelten kann für eine Prozessiervorrichtung anderen Typs, z.B. für eine Heizvorrichtung, eine Beschichtungsvorrichtung, eine Ätzvorrichtung, usw. Der Begriff "Beschichtungsvorrichtung" bezeichnet hierin eine Vorrichtung, die zum Durchführen eines schichtbildenden Prozesseses (auch als Beschichtungsprozess bezeichnet) eingerichtet ist und kann beispielsweise eine sogenannte Materialquelle aufweisen. Die Beschichtungsvorrichtung kann gemäß verschiedenen Ausführungsformen zum Beschichten zumindest eines Substrat (d.h. eines Substrats oder mehrere Substrate) eingerichtet sein, welches z.B. durch einen Beschichtungsbereich hindurch transportiert wird. Beispielsweise kann die Beschichtungsvorrichtung zum Bereitstellen eines gasförmigen Beschichtungsmaterials (Materialdampf) und/oder flüssigen Beschichtungsmaterials eingerichtet sein, welches z.B. auf dem zumindest einen Substrat zum Bilden einer Schicht abgeschieden werden kann. Beispiele für Komponenten einer Beschichtungsvorrichtung weisen auf: ein Sputtertarget als Materialquelle, eine Plasmaquelle, ein Tiegel als Materialquelle für ein thermisches Verdampfen des Beschichtungsmaterials (z.B. mittels eines Lasers, Lichtbogens, Elektronenstrahls und/oder konduktiv zugeführter Wärmeleistung), eine Präkursorquelle als Materialquelle, und/oder einen Flüssigphasenzerstäuber als Materialquelle. Eine Sputtervorrichtung kann zum Zerstäuben des Sputtertargets mittels eines Plasmas eingerichtet sein.

Bezüglich des schichtbildenden Prozesses wird Bezug genommen auf eine Dampfphasenabscheidung als exemplarischer Beschichtungsprozess, z.B. eine physikalische Gasphasenabscheidung (PVD), z.B. eine Kathodenzerstäubung (das sogenannte Sputtern) als exemplarische physikalische Gasphasenabscheidung. Die Gasphase des Beschichtungsmaterials kann bei der PVD optional chemisch reagiert werden mit einem Reaktivgas zu einer chemischen Verbindung, welches in die Schicht eingebaut wird oder diese bildet. Bei der chemischen Reaktion der PVD werden somit zwei oder mehr Materialien zu der chemischen Verbindung zusammengeführt. Es kann verstanden werden, dass das hierin für die CVD Beschriebene in Analogie für jeden anderen Beschichtungsprozess, gelten kann.

Der Begriff "Targetmaterial" bezeichnet hierin den Ausgangszustand des Beschichtungsmaterials, welcher beispielsweise fest oder flüssig sein kann. Der Begriff "Beschichtungsmaterial" bezeichnet hierin allgemein ein Material, mittels dessen der Beschichtungsprozess durchgeführt werden kann, bei dem eine oder mehr als eine Schicht gebildet wird (auch als Beschichten bezeichnet). Das Beschichtungsmaterial kann mehrere Zustände durchlaufen, die ineinander umgewandelt werden (z.B. chemisch reagieren) und/oder sich voneinander unterscheiden, beispielsweise in der chemischen Zusammensetzung, Ort des Beschichtungsmaterials und/oder Aggregatszustand. Der Ausgangszustand des Beschichtungsmaterials (dann auch als Targetmaterial bezeichnet) wird mittels eines sogenannten Targets bereitgestellt und kann, je nach Prozesstyp, das Schichtbildungsmaterial sein oder in das Schichtbildungsmaterial überführt werden. Beispielsweise kann das Targetmaterial chemisch zu dem Schichtbildungsmaterial reagieren (dann auch als reaktiver Beschichtungsprozess bezeichnet), z.B. mit einem reaktivgas und/oder einem anderen Beschichtungsmaterial, oder zu dem zu dem Schichtbildungsmaterial gemischt werden. Der Begriff "Schichtbildungsmaterial" bezeichnet den Endzustand des Beschichtungsmaterials, in welchem dieses die Schicht (deren chemische Zusammensetzung) bereitstellt. Beispielsweise kann die Schicht aus dem Schichtbildungsmaterial bestehen.

Im Kontext eines Sputterprozesses bezeichnet das Targetmaterial das zu zerstäubende Material (z.B. die chemische Zusammensetzung des Targets. Im Kontext eines thermischen Überführens in einen gasförmigen Zustand wird das Targetmaterial auch als Verdampfungsgut bezeichnet. Das Verdampfungsgut kann beispielsweise in einem Tiegel angeordnet sein oder werden.

Der Begriff "Sputtern" bezeichnet das Zerstäuben eines Materials (auch als Beschichtungsmaterial oder Targetmaterial bezeichnet) mittels eines Plasmas. Die zerstäubten Bestandteile des Targetmaterials werden somit voneinander separiert und können beispielsweise zum Bilden einer Schicht woanders angelagert werden. Das Sputtern kann mittels einer sogenannten Sputtervorrichtung erfolgen, welche ein Magnetsystem aufweisen kann (dann auch als Magnetron bezeichnet). Das Targetmaterial kann mittels eines sogenannten Sputtertargets bereitgestellt sein, welches beispielsweise rohrförmig (dann auch als Rohrtarget bezeichnet) oder plattenförmig (dann auch als Plattentarget bezeichnet) sein kann. Zum Erzeugen des Plasmas kann an das Sputtertarget (kurz auch als Target bezeichnet) eine Spannung angelegt werden, so dass das Sputtertarget als Kathode betrieben wird. Auch wenn die Spannung eine Wechselspannung aufweist, wird die Begrifflichkeit der Kathode beibehalten. Allgemeiner gesprochen wird hierin auf eine Lagervorrichtung Bezug genommen, welche zum Lagern eines rohrförmigen Targets (auch als Rohrtarget bezeichnet) oder eines planaren Targets (auch als Planartarget oder Plattentargets bezeichnet) eingerichtet sein kann. Im Fall eines Plattentargets, das nicht drehbar gelagert sein muss, kann die Lagervorrichtung ein starres Gestell aufweisen, welches das Plattentarget hält. Das Plattentarget kann beispielsweise eine oder mehr als eine Platte (z.B. Kachel) aufweisen, wobei mehrere Platten nebeneinander gehalten werden. Die Lagervorrichtung kann allgemein (z.B. bei einem Rohrtarget und einem Plattentarget) einen Träger aufweisen (auch als Magnetträger bezeichnet), welcher zum Halten des Magnetsystems eingerichtet ist. Der Magnetträger kann beispielsweise hohl sein und/oder eine Kühlvorrichtung implementieren, welche mit einem Kühlfluid versorgt werden kann.

Als räumliche Position wird hierin eine Angabe über die räumliche Ausrichtung und/oder den räumlichen Ort eines Objekts verstanden, beispielsweise bezogen auf eine oder mehr als eine Referenz (z.B. den Schwerpunkt) des Objekts.

Als Dichtungsvorrichtung wird hierin eine Vorrichtung zum Abdichten verstanden. Beispielhafte Komponenten (auch als Dichtkomponente bezeichnet) der Dichtungsvorrichtung weisen auf: eine oder mehr als eine Dichtfläche; eine Dichtungsnut; eine oder mehr als eine Dichtung (z.B. eine Metalldichtung oder eine Kunststoffdichtung). Die Kunststoffdichtung kann beispielsweise ein Elastomer aufweisen oder daraus bestehen (auch als Elastomerdichtung bezeichnet). Die Dichtungsvorrichtung (oder zumindest eine oder mehr als eine Dichtkomponente davon) Dichtung kann beispielsweise entlang eines in sich geschlossenen Pfades erstrecht sein. Beispielhafte Typen von Dichtungen weisen auf: Ringdichtung (z.B. O-Ring), Lippendichtung, Doppel-Lippendichtung. Beispielhafte Eigenschaften einer Dichtung weisen auf: eine Härte von weniger als 85 Shore-A; ringförmig; und/oder eine Dichtlippe aufweisend.

Der Begriff "Steuervorrichtung" kann als jede Art einer Logik implementierenden Entität verstanden werden, die beispielsweise eine Verschaltung und/oder einen Prozessor aufweisen kann, welche beispielsweise Software ausführen kann, die in einem Speichermedium, in einer Firmware oder in einer Kombination davon gespeichert ist, und darauf basierend Anweisungen ausgeben kann. Die Steuervorrichtung kann beispielsweise mittels Codesegmenten (z.B. Software) konfiguriert sein, um den Betrieb eines Systems (z.B. seines Arbeitspunkts), z.B. einer Maschine oder einer Anlage, z.B. zumindest seiner kinematischen Kette, zu steuern. Die Steuervorrichtung kann beispielsweise eine speicherprogrammierbare Steuervorrichtung (SPS) aufweisen oder daraus gebildet sein. Der Begriff "Prozessor" kann als jede Art von Entität verstanden werden, die die Verarbeitung von Daten oder Signalen erlaubt. Die Daten oder Signale können beispielsweise gemäß zumindest einer (d.h. einer oder mehr als einer) spezifischen Funktion behandelt werden, die vom Prozessor ausgeführt wird. Ein Prozessor kann eine analoge Schaltung, eine digitale Schaltung, eine Mischsignalschaltung, eine Logikschaltung, einen Mikroprozessor, eine zentrale Verarbeitungseinheit (CPU), eine Grafikverarbeitungseinheit (GPU), einen digitalen Signalprozessor (DSP), eine programmierbare Gatter-Anordnung (FPGA), eine integrierte Schaltung oder eine beliebige Kombination davon aufweisen oder daraus gebildet sein. Jede andere Art der Implementierung der jeweiligen Funktionen, die nachstehend ausführlicher beschrieben werden, kann auch als Prozessor oder Logikschaltung verstanden werden. Es versteht sich, dass einer oder mehrere der hierin detailliert beschriebenen Verfahrensschritte von einem Prozessor ausgeführt (z. B. realisiert) werden können, durch eine oder mehrere spezifische Funktionen, die von dem Prozessor ausgeführt werden.

Der Begriff "System" kann als ein Satz interagierender Entitäten verstanden werden. Beispiele für Entitäten des Systems weisen auf: zumindest eine (d.h. eine oder mehr als eine) mechanische Komponente, zumindest einen elektromechanischen Wandler (oder andere Arten von Stellgliedern), zumindest eine elektrische Komponente, zumindest eine Anweisung (z.B. in einem Speichermedium codiert und/oder mittels Codesegmenten implementiert), und/oder zumindest eine Steuervorrichtung.

Gemäß verschiedenen Ausführungsformen wird auf eine unebenes Substrat (auch als 3D-Substrat bezeichnet) Bezug genommen, worunter verstanden werden kann, dass das Substrat starr (z.B. selbsttragend) ist und dessen Geometrie makroskopisch von der einer planaren Platte abweicht. Beispiele für das Substrat weisen auf: eine Turbinenschaufel, eine gekrümmte Glasplatte, ein Werkzeug, usw. Alternativ oder zusätzlich kann das Substrat einen oder mehr als einen konkave Oberfläche und/oder eine oder mehr als eine konvexe Oberfläche aufweisen.

Der Begriff "atmosphärisch" bezieht sich hierin auf die Erdatmosphäre, z.B. deren Druck und/oder deren chemische Zusammensetzung (auch als Luft bezeichnet).

Der Begriff "Schnellkupplung" bezeichnet eine Kupplungsvorrichtung für zwei Leitungen (z.B. Fluidleitung, elektrische Leitung oder Medienleitung andren Typs), die eingerichtet ist, die zwei Leitungen (z.B. fluidleitend und/oder automatisch) miteinander zu koppeln, wenn diese aufeinander zu bewegt werden. Die Kupplungsvorrichtung kann mittels eines Steckers und einer Buchse implementiert werden, welche ineinander gesteckt werden können und eingerichtet sind, wenn diese ineinander greifen und/oder relativ zueinander bewegt werden, optional formschlüssig aneinander arretiert werden können, beispielsweise mittels eines Rastmechanismus oder eines Dreh-Verschlusses. Hierin werden verschiedene Implementierungen des Prozessiervorrichtung-Wechselsystems und Verfahren hierfür erläutert, insbesondere im Kontext einer Vakuumanordnung und/oder einer Steuervorrichtung. Diesbezüglich kann verstanden werden, dass das hierfür Beschriebene in Analogie gelten kann für ein einzeln bereitgestelltes Prozessiervorrichtung-Wechselsystem und/oder Verfahren dafür, welche beispielsweise nicht notwendigerweise als Teil der Vakuumanordnung bereitgestellt werden muss.

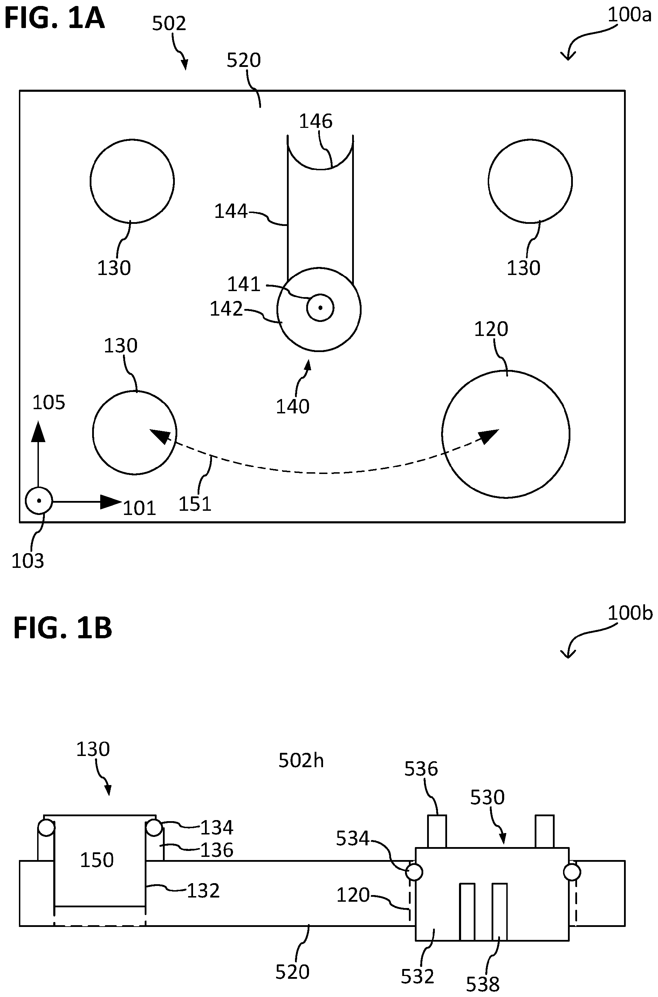

**Fig.1A** veranschaulicht ein Prozessiervorrichtung-Wechselsystem gemäß verschiedenen Ausführungsformen 100a, vorzugsweise eingerichtet gemäß Beispiel 1, in einer schematischen Seitenansicht oder Querschnittsansicht mit Blick auf eine Kammerwand 520 des Vakuumkammergehäuses 502, welche von der Transferöffnung 120 durchdrungen ist (dann auch als Transferwand 520 bezeichnet). Eine exemplarische Implementierung der Transferöffnung 120 durchdringt die Transferwand 520 entlang einer Richtung 103 (auch als Transferrichtung bezeichnet).

Eine exemplarische Implementierung des Vakuumkammergehäuse 502 weist mehrere Kammerwände auf, welche einen Hohlraum (auch als Kammerinneres oder als Kammerinnenraum bezeichnet) begrenzen. Beispiele für die Transferwand 520 weisen auf: Kammerdecke, Kammerboden, Kammerseitenwand. Der Kammerboden begrenzt das Kammerinnere nach unten. Die Kammerdecke begrenzt das Kammerinnere nach oben. Die Kammerseitenwand begrenzt das Kammerinnere in seitlicher Richtung, z.B. entlang der Horizontale. Die Transferwand 520 begrenzt den Kammerinnenraum 502h (siehe auch Fig.1B), welcher an jeden Kammersockel, z.B. Aufbewahrungssockel 130 und/oder Transfersockel (insofern vorhanden), angrenzt.

Die mehreren ersten Lagersockel 130 (auch als Aufbewahrungssockel 130 bezeichnet) weisen beispielsweise 2 oder mehr, z.B. 3 oder mehr, z.B. 4 oder mehr, z.B. 5 oder mehr Aufbewahrungssockel 130 auf. Eine exemplarische Implementierung jedes Aufbewahrungssockels weist eine Aussparung (auch als Aufnahmeraum bezeichnet) auf, welche in dem Kammerinneren mündet.

Eine exemplarische Implementierung der Transportvorrichtung 140 weist eine Lagervorrichtung 142 und einen Greifarm 144 auf, dem mittels der Lagervorrichtung 142 eine Drehachse 141 (auch als Greiferdrehachse 141 bezeichnet) bereitgestellt ist. Der Greifarm 144 ist um die Greiferdrehachse 141 drehbar gelagert und optional entlang der Greiferdrehachse 141 verschiebbar gelagert. Der Greifarm 144 weist einen Arm und einen Greifer 146 als Aktuator auf, wobei der Arm den Greifer 146 mit der Lagervorrichtung 142 kuppelt. Optional kann der Arm mehrere Segmente und (z.B. pro Segment) ein oder mehr als ein Gelenk aufweisen, welches zwei Segmente des Arms miteinander kuppelt. Der Greifer 146 kann, muss aber nicht notwendigerweise beweglich sein, sondern kann auch starr eingerichtet sein, z.B. in Form einer Gabel (auch als Greifergabel bezeichnet).

Die Transportvorrichtung 140 stellt pro Aufbewahrungssockel 130 einen Transportpfad 151 (exemplarisch nur ein Transportpfad dargestellt) bereit, entlang dessen eine Prozessiervorrichtung transportiert werden kann von dem Aufbewahrungssockel 130 zu der Transferöffnung 120 und/oder von der Transferöffnung 120 zu dem Aufbewahrungssockel 130.

Im Betrieb kann eine Transportsequenz initiiert werden, gemäß welcher eine Prozessiervorrichtung in dem Kammergehäuse mittels der Transportvorrichtung 140 transportiert wird. Die Transportsequenz kann aufweisen, einen der Aufbewahrungssockel 130 (dann auch als Auswahlsockel bezeichnet) auszuwählen (auch als Auswahlprozess bezeichnet). Ferner kann mittels der Transportvorrichtung 140 eine Prozessiervorrichtung von der Transferöffnung 120 zu dem Auswahlsockel transportiert werden oder von dem Auswahlsockel zu der Transferöffnung 120 transportiert werden, wie später noch genauer erläutert wird.

**Fig.1****B** veranschaulicht ein Prozessiervorrichtung-Wechselsystem gemäß verschiedenen Ausführungsformen 100b in einer schematischen Seitenansicht oder Querschnittsansicht, vorzugsweise eingerichtet gemäß Ausführungsformen 100a und/oder Beispiel 2.

Eine exemplarische Implementierung des Endeffektors 530 ist eingerichtet, zumindest teilweise in die Transferöffnung 120 hinein gestreckt zu werden. Optional können der Endeffektor 530 und die Transferöffnung 120 derart zueinander eingerichtet sein, dass die Transferöffnung 120 mittels des Endeffektors 530 vakuumdicht abgedichtet werden kann. Alternativ oder zusätzlich kann eine Dichtvorrichtung 534 (auch als Transferdichtung bezeichnet) vorhanden sein, welche eingerichtet ist, einen Spalt zwischen dem Endeffektor 530 und der Transferwand 520 vakuumdicht abzudichten. Die Transferdichtung 534 kann beispielsweise an dem Endeffektor 530 oder der Transferwand 520 befestigt sein.

Die exemplarische Implementierung des Endeffektors 530 weist ferner ein Gestell 532 (auch als Endeffektorgestell bezeichnet) auf, welches eingerichtet ist, zumindest teilweise in der Transferöffnung 120 aufgenommen zu werden, und/oder welches einen Hohlraum (auch als Anschlussraum bezeichnet) aufweist. Ferner weist der Endeffektor 530 einen zweiten Lagersockel 536 (auch als Prozesssockel 536 bezeichnet) auf, welcher eingerichtet ist, die Prozessiervorrichtung aufzunehmen.

Eine exemplarische Implementierung des Endeffektorgestells 532 weist eine Öffnung (auch als Endeffektor-Sockelöffnung bezeichnet) auf, die beispielsweise eine Vertiefung oder eine Durchgangsöffnung sein kann, welche in dem Aufnahmeraum des Prozesssockels mündet oder diesen bereitstellt. Alternativ oder zusätzlich kann die Endeffektor-Sockelöffnung in dem Anschlussraum des Endeffektorgestells 532 münden. Beispielsweise kann jede Endeffektor-Sockelöffnung, welche in dem Aufnahmeraum des Prozesssockels mündet oder diesen bereitstellt, vakuumdicht mittels der Prozessiervorrichtung verschlossen werden.

Eine exemplarische Implementierung (vorzugsweise gemäß Beispiel 3) des Anschlusssystems 538 weist zumindest eine (d.h. eine oder mehr als eine) Schnellkupplung, z.B. pro Medientyp eine oder mehr als eine Schnellkupplung aufweisend, auf, die vorzugsweise in dem Gestell (z.B. dessen Anschlussraum) angeordnet ist. Beispiele für Komponenten der zumindest einen Schnellkupplung weisen auf: eine zum Austauschen elektrischer Leistung eingerichtete erste Schnellkupplung, und/oder eine zum Austauschen eines Kühlfluids, z.B. einer Kühlflüssigkeit (z.B. Wasser aufweisend), eingerichtete zweite Schnellkupplung auf; und/oder eine oder mehr als eine zum Austauschen eines Gases (z.B. Prozessgases), eingerichtete dritte Schnellkupplung. Jede der zumindest einen Schnellkupplung kann derart eingerichtet sein, dass diese an die Prozessiervorrichtung automatisch ankuppelt, wenn diese in den Prozesssockel eingebracht wird. Dies vereinfacht den Betrieb.

Jeder Lagersockel (z.B. der Prozesssockel 536, ein Transfersockel und/oder jeder Aufbewahrungssockel 130) weisen einen Aufnahmeraum auf, welcher eingerichtet ist, die Prozessiervorrichtung aufzunehmen, in welchen die Prozessiervorrichtung beispielsweise zumindest hinein hineinragen kann, wenn diese von dem Sockel aufgenommen ist. Der Aufnahmeraum ist von einer Aufnahmefläche umgeben und/oder grenzt an diese an. Die Aufnahmefläche kann an der Prozessiervorrichtung (z.B. deren Dichtvorrichtung) anliegen, wenn diese von dem Lagersockel aufgenommen ist. Beispielsweise kann die Aufnahmefläche mittels einer Dichtvorrichtung (insofern vorhanden) des Lagersockel bereitgestellt sein und/oder den Aufnahmeraum entlang eines in sich geschlossenen Pfades umgeben.

Ist der Lagersockel vom Typ des Montagesockels (z.B. der Prozesssockel 536 und/oder jeder Aufbewahrungssockel 130) weist der Sockel eine Montagevorrichtung 136 auf, wie später noch genauer erläutert wird.

Eine exemplarische Implementierung der Transferwand 520 weist pro Lagersockel vom Typ des Kammersockels (z.B. Aufbewahrungssockel 130 und/oder Transfersockel) eine Öffnung 132 (auch als Sockelöffnung bezeichnet) auf, die beispielsweise eine Vertiefung oder eine Durchgangsöffnung sein kann, welche in dem Aufnahmeraum des Kammersockels mündet oder diesen bereitstellt. Beispielsweise kann jede Sockelöffnung 132, welche in dem Aufnahmeraum des Aufbewahrungssockel 130 mündet oder diesen bereitstellt (auch als offene Sockelöffnung 132 bezeichnet), das Kammerinnere mit einem Äußeren des Vakuumkammergehäuses 502 fluidleitend koppeln.

Eine exemplarische Implementierung jeder Sockelöffnung 132 ist derart eingerichtet, dass die Prozessiervorrichtung 150 zumindest teilweise in die Sockelöffnungen 132 hinein gestreckt werden kann. Optional können die Prozessiervorrichtung 150 und der Kammersockel derart zueinander eingerichtet sein, dass die Sockelöffnung des Kammersockels mittels der Prozessiervorrichtung 132 vakuumdicht abgedichtet werden kann. Alternativ oder zusätzlich kann eine Dichtvorrichtung 134 vorhanden sein, welche eingerichtet ist, einen Spalt zwischen der Prozessiervorrichtung 150 und der Transferwand 520 vakuumdicht abzudichten. Die Dichtvorrichtung 134 kann beispielsweise an der Prozessiervorrichtung 150 oder der Transferwand 520 befestigt sein.

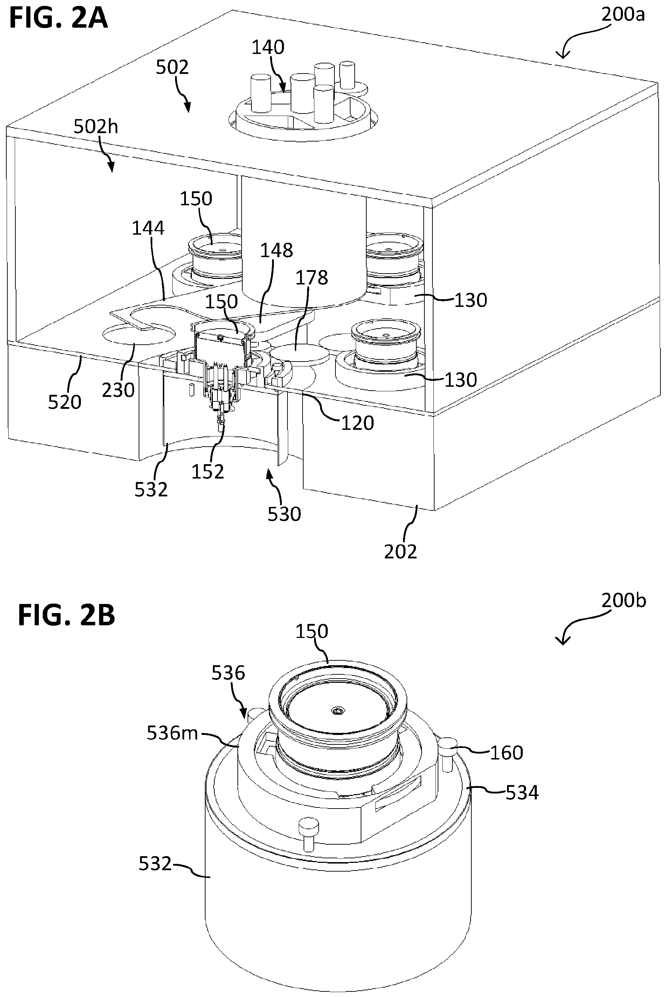

**Fig.2A** veranschaulicht ein Prozessiervorrichtung-Wechselsystem gemäß verschiedenen Ausführungsformen 200a in einer schematischen geschnittenen Perspektivansicht, vorzugsweise eingerichtet gemäß einer der Ausführungsformen 100a bis 100b und/oder Beispiel 4.

Eine exemplarische Implementierung des dritten Lagersockels 230 (auch als Transfersockel bezeichnet) grenzt an den Kammerinnenraum 151 des Kammergehäuses 151 an und/oder weist keine Montagevorrichtung auf. Eine exemplarische Implementierung der Kammerwand 520 weist pro Transfersockel 230 eine Sockelöffnung (nicht dargestellt) auf, die beispielsweise eine Vertiefung oder ein Durchgangsöffnung sein kann, welche in dem Aufnahmeraum des Transfersockels 230 mündet oder diesen bereitstellt.

Eine exemplarische Implementierung der Sockelöffnung, welche in dem Aufnahmeraum des Transfersockels 230 mündet oder diesen bereitstellt (auch als Sockelöffnung zweiten Typs bezeichnet), ist gegenüber dem Äußeren des Vakuumkammergehäuses 502 vakuumdicht separiert, z.B. mittels eines (z.B. topfförmigen) Gehäuses (auch als Separationsgehäuse bezeichnet), welcher an der Kammerwand 520 anliegt und in welchem die Sockelöffnung des Transfersockels 230 mündet. Mit anderen Worten unterscheidet sich der Aufnahmeraum des Transfersockels von dem Aufnahmeraum jedes Aufbewahrungssockel darin in der vakuumdichten Separierung und damit der Zugänglichkeit. Die vakuumdichte Separierung des Transfersockels 230 ermöglicht es, den Kammerinnenraum auch dann abpumpen zu können, wenn keine Prozessiervorrichtung in dem Transfersockel 230 aufgenommen ist. Alternativ oder zusätzlich unterscheidet sich der Transfersockel 230 von dem Aufbewahrungssockel 130 darin, dass der Transfersockel 230 keine Montagevorrichtung und/oder keine Dichtvorrichtung (oder zumindest weniger davon) aufweist. Dies vereinfacht den Betrieb und reduziert Kosten. Der Transfersockel 230 kann anschaulich einen temporären Lagerort für die Prozessiervorrichtung bereitstellen, so dass der Wechselvorgang vereinfacht werden kann.

Optional kann eine oder mehr als eine Betätigungsvorrichtung, z.B. die Sockel-Betätigungsvorrichtung 148 und/oder die Transfer-Betätigungsvorrichtung 178, in dem Kammergehäuse angeordnet sein. Zu jeder Betätigungsvorrichtung kann ein oder mehr als ein Verriegelungsmechanismus vorhanden sein, welcher mittels der Betätigungsvorrichtung betätigt werden kann, um diesen in einen ersten Zustand (auch als verriegelnden Zustand bezeichnet) und einen zweiten Zustand (auch als unverriegelten Zustand bezeichnet) zu bringen.

Die Sockel-Betätigungsvorrichtung 148 ist beispielsweise eingerichtet, einen ersten Verriegelungsmechanismus in den verriegelnden Zustand oder den unverriegelten Zustand zu bringen. Der erste Verriegelungsmechanismus (auch als Sockel- Verriegelungsmechanismus bezeichnet) kann eingerichtet sein, in den verriegelnden Zustand gebracht, eine Bewegung einer Prozessiervorrichtung, welche in einem Montagesockel aufgenommen ist, relativ zu dem Montagesockel 130 (vollständig oder zumindest von diesem weg) zu blockieren, und in den zweiten Zustand gebracht, die Bewegung freizugeben (d.h. die Blockade aufzuheben). Der erste Verriegelungsmechanismus kann beispielsweise mittels eines Montagesockels (z.B. dessen Montagevorrichtung oder einer davon separaten Verriegelungsvorrichtung) implementiert werden.

Die Transfer-Betätigungsvorrichtung 178 ist beispielsweise eingerichtet, einen zweiten Verriegelungsmechanismus in den verriegelnden Zustand oder den unverriegelten Zustand zu bringen. Der zweite Verriegelungsmechanismus (auch als Endeffektor-Verriegelungsmechanismus bezeichnet) kann eingerichtet sein, in den verriegelnden Zustand gebracht, eine Bewegung des Endeffektors, welcher an der Transferwand anliegt, relativ zu der Transferwand (vollständig oder zumindest von dieser weg) zu blockieren, und in den zweiten Zustand gebracht, die Bewegung freizugeben (d.h. die Blockade aufzuheben). Der zweite Verriegelungsmechanismus kann beispielsweise mittels der Transferwand 520 (z.B. einer Montagevorrichtung dieser oder einer davon separaten Verriegelungsvorrichtung) implementiert werden.

**Fig.2B** veranschaulicht einen Prozessiervorrichtung-Wechselsystem gemäß verschiedenen Ausführungsformen 200b in einer schematischen Perspektivansicht, vorzugsweise eingerichtet gemäß Ausführungsformen 100a bis 200a und/oder gemäß Beispiel 29. Die Montagevorrichtung 536m des Endeffektors kann von dem Endeffektorgestell 532 hervorstehen und/oder rohrförmig sein.

Eine exemplarische Implementierung des Endeffektorgestells 532 stellt ein Gestellgehäuse (auch als Trägergehäuse bezeichnet) bereit, auf welchem die Prozessiervorrichtung in der Beschichtungsphase vakuumgedichtet aufliegt. Innerhalb des Trägergehäuses, z.B. dessen Anschlussraum, kann beispielsweise atmosphärischer Druck (auch als Atmosphärendruck bezeichnet) herrschen, dem das Anschlusssystem der Prozessiervorrichtung 150 ausgesetzt ist. Der Anschluss erfolgt beispielsweise mittels einer Atmosphärenzuleitung (z.B. eines Schlauchs).

Eine exemplarische Implementierung der Montagevorrichtung 536m des Endeffektors ist eingerichtet, einen Bajonettverschluss zu implementieren. Mittels des Bajonettverschlusses kann die Prozessiervorrichtung gehalten und arretiert werden.

Eine exemplarische Implementierung des Endeffektors weist die Transferdichtung 534 als Dichtvorrichtung (z.B. eine Dichtfläche aufweisend) und mehrere (z.B. pilzförmige) Vorsprünge 160 (z.B. Verriegelungsdornen) auf, welche eingerichtet sind, formschlüssig mit dem Kammergehäuse und/oder einer an die Transferöffnung angrenzenden Montagevorrichtung (auch als Transfer-Montagevorrichtung bezeichnet) ineinanderzugreifen zum Arretieren des Endeffektors mit dem Kammergehäuse (z.B. mittels der Montagevorrichtung).

Eine exemplarische Implementierung des Endeffektors (z.B. dessen Trägergehäuse) ist eingerichtet, federbelastet mit dem Roboter (z.B. dessen kinematischer Kette) gekuppelt zu werden.

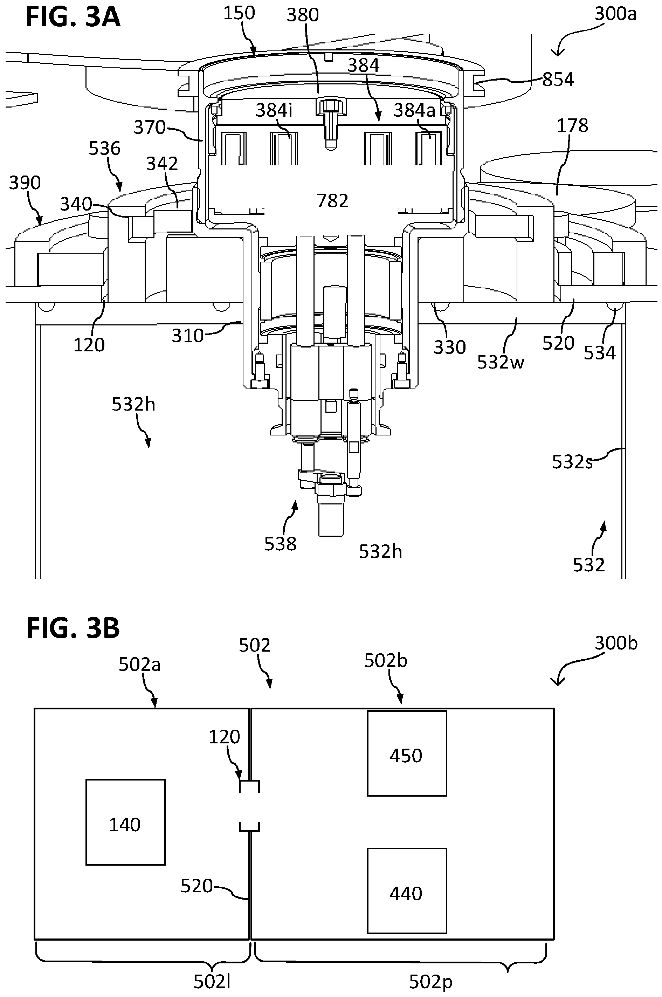

**Fig.3A** veranschaulicht ein Prozessiervorrichtung-Wechselsystem gemäß verschiedenen Ausführungsformen 300a in einer schematischen geschnittenen Detailansicht, vorzugsweise eingerichtet gemäß einer der Ausführungsformen 100a bis 200b und/oder Beispiel 2.

Eine exemplarische Implementierung des Endeffektorgestells 532 weist eine Wand 532w (auch als Gestelldecke bezeichnet) auf, welche von der Endeffektor-Sockelöffnung 310 durchdrungen ist. Die Gestelldecke 532w grenzt an mehrere Dichtvorrichtungen (z.B. eine erste Dichtvorrichtungen und eine zweite Dichtvorrichtungen) an, wovon jede Dichtvorrichtungen die Endeffektor-Sockelöffnung 310 entlang eines in sich geschlossenen Pfades umgibt. Alternativ oder zusätzlich weist das Gestells ein Gestellgehäuse 532s (beispielsweise mittels einer oder mehr als einer zweite Wand bereitgestellt) auf, welches einen mittels der Prozessiervorrichtung abdichtbaren Hohlraum 532h (auch als Anschlussraum bezeichnet) bereitstellt, in welchen das Anschlusssystem 538 hinein erstreckt sein kann. Passend zu dem Anschlusssystem 538 kann in dem Anschlussraum 532h ein Anschlussterminal (nicht dargestellt) angeordnet sein, welches eingerichtet ist, mit dem Anschlusssystem 538 eine (z.B. elektrisch leitfähige und/oder fluidleitfähige, z.B. gasleitfähige) Verbindung herzustellen, z.B. wenn diese aufeinander zu bewegt werden. Mittels der gasleitfähigen Verbindung kann beispielsweise ein Prozessgas vermittelt werden, das beispielsweise ein Arbeitsgas und/oder ein Reaktivgas aufweisen kann.

Eine exemplarische Implementierung des Anschlusssystems 538, welches beispielsweise einen oder mehr als einen Anschluss (auch als Quellenanschschluss bezeichnet) aufweisen kann, wird mittels einer Schnellkupplung mit dem Anschlussterminal in dem Trägergehäuse gekuppelt, wobei das Anschlussterminal mit den entsprechenden Medienleitungen (z.B. für elektrische Energie und/oder Kühlfluid) gekoppelt ist.

Eine exemplarische Implementierung der ersten Dichtvorrichtungen 534 (auch als Transferdichtung bezeichnet) weist eine Dichtnut auf, die eingerichtet ist, eine erste Dichtung (z.B. Ringdichtung) aufzunehmen. Die Transferdichtung 534 kann an der Transferwand 520 vakuumdicht anliegen, wenn der Endeffektor in der Transferöffnung 120 aufgenommen ist.

Eine exemplarische Implementierung der zweiten Dichtvorrichtungen 330 stellt die Sockeldichtung des Prozesssockels bereit.

Eine exemplarische Implementierung eines oder mehr als eines (z.B. jedes) Montagesockels (z.B. der Prozesssockel und/oder jeder Aufbewahrungssockel 130) weist eine solche Sockeldichtung auf. Die Sockeldichtung weist eine Dichtnut auf, die eingerichtet ist, eine Dichtung (z.B. Ringdichtung) der Sockeldichtung aufzunehmen. Die Sockeldichtung kann an der Prozessiervorrichtung 150 vakuumdicht anliegen, wenn die Prozessiervorrichtung 150 in dem Montagesockel aufgenommen ist. Ferner weist die exemplarische Implementierung des Montagesockels eine Montagevorrichtung 536m, 136 auf, welche beispielsweise eine (z.B. ringförmige und/oder nutförmige) Aussparung 340 aufweisen kann, die einen Bajonettverschluss implementiert (dann auch als Bajonett-Aussparung bezeichnet). Passend dazu weist die Prozessiervorrichtung 150 einen Vorsprung 342 auf, welcher den Bajonettverschluss implementiert (auch als Bajonett-Vorsprung bezeichnet) und eingerichtet ist, in die Bajonett-Aussparung hineinzugreifen.

Eine exemplarische Implementierung des Bajonettverschlusses ist eingerichtet, wenn die Prozessiervorrichtung 150 relativ zu dem Montagesockel (z.B. der Prozesssockel und/oder jeder Aufbewahrungssockel 130) gedreht wird, eine Kraft zu generieren, welche die Prozessiervorrichtung und die Transferdichtung 534 gegeneinander presst. Dies erleichtert den Betrieb, insbesondere die Abdichtung.

In ähnlicher Weise können der Endeffektor (z.B. ein Vorsprung dessen) und die Transferwand 520 (oder eine daran befestigte Montagevorrichtung) eingerichtet sein, einen Bajonettverschluss 390 zu implementieren, welcher eingerichtet ist, wenn der Endeffektor relativ zu der Transferwand 520 gedreht wird, eine Kraft zu generieren, welche den Endeffektor und die Transferwand 520 gegeneinander presst. Dies erleichtert den Betrieb, insbesondere die Abdichtung. Dazu kann beispielsweise eine Kupplungsvorrichtung vorhanden sein, welche eingerichtet ist, den Bajonettverschluss zu implementieren.

Eine exemplarische Implementierung einer oder mehr als einer (z.B. jeder) Prozessiervorrichtung 150 ist als Sputtervorrichtung eingerichtet. Die Sputtervorrichtung weist beispielsweise ein Sputtertarget 380 auf, welches vorzugsweise planar (dann auch als Planartarget bezeichnet) und/oder ringförmig ist. Ferner weist die Sputtervorrichtung ein Magnetsystem 384 auf, welches mehrere Magnetpole (z.B. einen Innenpol 384i und einen Außenpol 384a) aufweist, welche sich beispielsweise in ihrer Magnetisierungsrichtung voneinander unterscheiden. Der Innenpol 384i und/oder der Außenpol 384a können entlang eines in sich geschlossenen Pfades erstreckt sein. Beispielsweise kann der Außenpol ein magnetischer Nordpol sein, wenn der Innenpol ein magnetischer Südpol ist. Alternativ kann der Innenpol ein magnetischer Nordpol sein, wenn der Außenpol ein magnetischer Südpol ist.

Die Sputtervorrichtung weist ferner eine Lagervorrichtung 782 auf, mittels welcher das Magnetsystem 384 und/oder das Target 380 gelagert sind, z.B. starr zueinander.

Ferner kann die Prozessiervorrichtung 150 ein Gehäuse 370 aufweisen, in welchem das Magnetsystem (insofern vorhanden) angeordnet ist und/oder an welchem das Sputtertarget und/oder das Anschlusssystem 538 montiert sind. Das Gehäuse kann beispielsweise die Gegen-Montagevorrichtung aufweisen, welche komplementär zu einem oder mehr als einem Montagesockel (z.B. dessen Montagevorrichtung) eingerichtet ist.

Eine exemplarische Implementierung (vorzugsweise gemäß Beispiel 3) des Anschlusssystems 538 (z.B. der ersten Schnellkupplung davon) ist mit einer Kühlvorrichtung der Prozessiervorrichtung 150 gekuppelt und eingerichtet, die Kühlvorrichtung mit einem Kühlfluid (z.B. einer Kühlflüssigkeit) zu versorgen. Alternativ oder zusätzlich ist das Anschlusssystem 538 (z.B. deren zweite Schnellkupplung) mittels einer elektrischen Leitung mit dem Sputtertarget 380 gekoppelt und eingerichtet, das Sputtertarget 380 mit elektrischer Leistung zu versorgen. Alternativ oder zusätzlich ist das Anschlusssystem 538 (z.B. deren zweite Schnellkupplung) mittels einem Gasauslass der Prozessiervorrichtung 150 gekoppelt und eingerichtet, den Gasauslass mit einem Gas, z.B. Prozessgas, zu versorgen.

Eine exemplarische Implementierung der Kühlvorrichtung ist eingerichtet, dem Sputtertarget und/oder dem Magnetsystem thermische Energie zu entziehen, beispielsweise mittels des Kühlfluids. Dies erlaubt, die dem Sputtertarget zugeführte elektrische Leistung zu vergrößern.

**Fig.3B** veranschaulicht eine Vakuumanordnung gemäß verschiedenen Ausführungsformen 300b in einem schematischen Aufbaudiagramm, vorzugsweise eingerichtet gemäß einer der Ausführungsformen 100a bis 300a und/oder gemäß Beispiel 23.

Eine exemplarische Implementierung des Kammergehäuses 502 ist als monolithischer Verbund bereitgestellt oder weist mehrere einzelne Segmente (auch als Gehäusesegmente bezeichnet) auf (dann auch als mehrteiliges Kammergehäuse bezeichnet), wovon jedes Gehäusesegment eine oder mehr als eine Vakuumkammer bereitstellt und/oder mehrere Kammerwände aufweist. Jedes der Gehäusesegmente 502a, 502b weist eine Kammerwand auf, welche von einer Durchgangsöffnung 510 durchdrungen ist, welche die Transferöffnung 120 bereitstellt.

Das Kammergehäuse 502 (z.B. ein erstes Gehäusesegment 502a dessen) stellt eine erste Vakuumkammer (auch als Wechselkammer 502l bezeichnet) bereit, welche beispielsweise als Schleusenkammer eingerichtet sein kann und in welcher die Transportvorrichtung 140 und/oder die Kammersockel angeordnet sind. Das Kammergehäuse 502 (z.B. ein zweites Gehäusesegment 502b dessen) stellt eine zweite Vakuumkammer (auch als Prozessierkammer 502p bezeichnet) bereit, in welcher der Roboter 440 und/oder die Substrathaltevorrichtung 450 angeordnet sind. Zwischen der Prozessierkammer und der Wechselkammer ist die Transferwand aufweisen, welche von der Transferöffnung 520 durchdrungen ist, die in der Prozessierkammer und der Wechselkammer mündet.

Eine exemplarische Implementierung der Substrathaltevorrichtung 450 ist eingerichtet, das Substrat ortsfest zu halten in einer Position (auch als Prozessier-Position bezeichnet) in der Prozessierkammer. Das Substrat kann beispielsweise eine gekrümmte und/oder gekantete Geometrie aufweisen. Beispielsweise kann das Substrat eine oder mehr als eine konvexe Oberfläche und/oder eine oder mehr als eine konkave Oberfläche aufweisen.

Eine exemplarische Implementierung des Roboters 440 weist einen Roboterarm als kinematische Kette auf, welcher eingerichtet ist, dem Endeffektor mehr als 3 (z.B. 4, 5 oder 6) Freiheitsgrade bereitzustellen. Beispiele für die Freiheitsgrade des Endeffektors weisen auf: drei Translationsfreiheitsgrade und/oder einen oder mehr als einen Rotationsfreiheitsgrad. Der Roboterarm weist eine Montagevorrichtung auf, an welcher der Endeffektor montiert sein oder werden kann.

Der Roboter 440 kann beispielsweise mittels einer Steuervorrichtung und/oder gemäß einem Bewegungsschema angesteuert werden. Das Bewegungsschema kann beispielsweise derart eingerichtet sein, dass der Endeffektor 530, z.B. die darin aufgenommene Prozessiervorrichtung 150, das Substrat entlang eines Bewegungspfads abfährt, so dass dieses mittels der Prozessiervorrichtung 150 gleichmäßig prozessiert (z.B. beschichtet) wird.

Die Wechselkammer 502l ist beispielsweise im Betrieb mit einer ersten Pumpenanordnung, z.B. einer Vakuumpumpenanordnung, (z.B. gasleitend) gekoppelt, welche zumindest eine Hochvakuumpumpe aufweist. Die Prozessierkammer 502p ist beispielsweise im Betrieb mit einer zweiten Pumpenanordnung, z.B. einer Vakuumpumpenanordnung, (z.B. gasleitend) gekoppelt, welche zumindest eine Hochvakuumpumpe aufweist. und/oder separat von der ersten Pumpenanordnung ist.

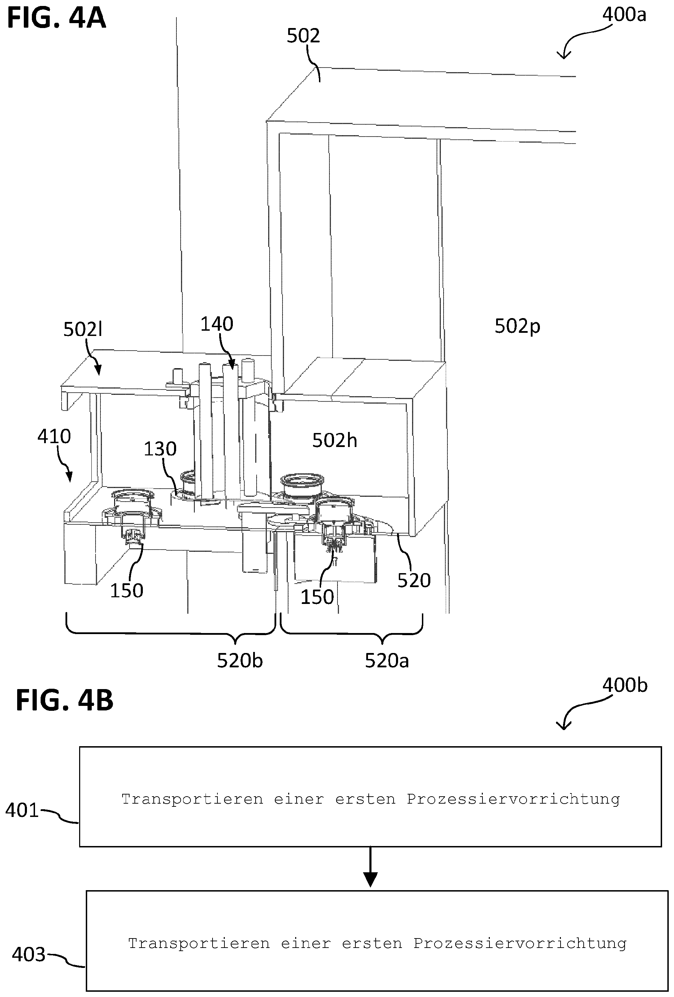

**Fig.4A** veranschaulicht eine Vakuumanordnung gemäß verschiedenen Ausführungsformen 400a in einer schematischen geschnittenen Perspektivansicht, vorzugsweise eingerichtet gemäß einer der Ausführungsformen 100a bis 300b und/oder gemäß Beispiel 23.

Eine exemplarische Implementierung der Transferwand 520 weist mehrere Abschnitte auf, wovon ein erster Abschnitt 520a (auch als Innenabschnitt 520a bezeichnet) in die Prozessierkammer hineinragt und ein zweiter Abschnitt 520b (auch als Außenabschnitt bezeichnet) von der Prozessierkammer hervorsteht. Alternativ oder zusätzlich ragt der Kammerinnenraum 502h abschnittsweise in die Prozessierkammer hinein und steht abschnittsweise von der Prozessierkammer hervor. Diese Geometrie (auch als Halboffen-Geometrie bezeichnet) erleichtert den Zugang zu den Prozessiervorrichtungen, welche in den Aufbewahrungssockeln 130 aufgenommen sind.

Eine exemplarische Implementierung des Innenabschnitts 520a ist von der Transferöffnung durchdrungen. Alternativ oder zusätzlich ist der Außenabschnitt 520b von den Sockelöffnungen eines oder mehr als eines Kammersockels (z.B. jedes Aufbewahrungssockels 130) durchdrungen. Ferner kann das Separationsgehäuse an dem Außenabschnitt 520b anliegen, in welchem die Sockelöffnungen des Transfersockels mündet.

Ist die Wechselkammer 502l als Schleusenkammer eingerichtet, weist das Kammergehäuse 502 eine Kammeröffnung 410, welche in der Wechselkammer mündet, und einen dazu passenden Kammerdeckel auf, welcher eingerichtet ist, in einem geschlossenen Zustand die Kammeröffnung vakuumdicht zu verschließen.

Im der Halboffen-Geometrie ist der Außenabschnitt 520b einen atmosphärischem Druck (der Erdatmosphäre) ausgesetzt, beispielsweise wenn der Kammerinnenraum 502h abgepumpt ist. Im Betrieb ist die Rückseite (z.B. das Anschlusssystems 538) jeder Prozessiervorrichtung 150, wenn diese in einem Aufbewahrungssockel 130 aufgenommen ist, einen atmosphärischem Druck (der Erdatmosphäre) ausgesetzt, beispielsweise wenn der Kammerinnenraum 502h abgepumpt ist.

**Fig.4B** veranschaulicht ein Verfahren gemäß verschiedenen Ausführungsformen 400b in einem schematischen Ablaufdiagramm, vorzugsweise eingerichtet gemäß einer der Ausführungsformen 100a bis 400a und/oder gemäß Beispiel 19 und/oder Beispiel 25.

Das Verfahren weist auf, in 401, Transportieren einer ersten Prozessiervorrichtung, z.B.
- in einer ersten Transportphase (TP1) und/oder mittels der Transportvorrichtung 140, z.B. von der Transferöffnung 120 weg oder zu dieser hin, vorzugsweise um die erste Prozessiervorrichtung zwischen dem Endeffektor und der Transportvorrichtung zu übergeben (auch als Transferieren bezeichnet) und/oder wenn die zweite Prozessiervorrichtung von dem Transfersockel aufgenommen ist; und/oder
in einer ersten Beschichtungsphase (BP1) und/oder mittels des Roboters, beispielsweise von der Transferöffnung weg (z.B. aus dieser heraus), zu der Transferöffnung hin (z.B. in diese hinein) und/oder wenn das Prozessieren des Substrats mittels der ersten Prozessiervorrichtung erfolgt.

Das Verfahren weist auf, in 403, Transportieren einer zweiten Prozessiervorrichtung:
- in einer zweiten Transportphase (TP2) und/oder mittels der Transportvorrichtung, z.B. zu der Transferöffnung hin oder von der Transferöffnung weg, vorzugsweise um die zweite Prozessiervorrichtung zwischen dem Endeffektor und der Transportvorrichtung zu übergeben und/oder wenn die erste Prozessiervorrichtung von dem Transfersockel aufgenommen ist; und/oder
in einer zweiten Beschichtungsphase (BP2) und/oder mittels des Roboters, beispielsweise von der Transferöffnung weg (z.B. aus dieser heraus), zu der Transferöffnung hin (z.B. in diese hinein) und/oder wenn das Prozessieren des Substrats mittels der zweiten Prozessiervorrichtung erfolgt.

Im Folgenden werden verschiedene Arbeitsbeispiele beschrieben, die sich auf das hierin Beschriebene und in den Figuren Dargestellte beziehen und/oder eingerichtet sind gemäß einem der Beispiele 1 bis 54. Dabei bezeichnen:
- "AS" einen der mehreren Aufbewahrungssockel, welche mittels natürlicher Zahlen referenziert sind (AS1, AS2, usw.);
- "PV" eine der mehreren Prozessiervorrichtungen, welche mittels natürlicher Zahlen referenziert sind (PV1, PV2, usw.);
- "TS" den Transfersockel (insofern vorhanden);
- "PS" den Prozesssockel;
- "BP" eine der Beschichtungsphasen, welche mittels natürlicher Zahlen referenziert sind (BP1, BP2, usw.);
- "TP" eine der Transportphasen, welche mittels natürlicher Zahlen referenziert sind (TP1, TP2, usw.);
- "ZA" einen Zeitabschnitt; und
   "TV" die Transportvorrichtung.

| Arbeitsbeispiel 1 | AS1 | AS2 | AS3 | TS | TV | PS |
|---|---|---|---|---|---|---|
| ZA | | | | | | |
| 1 | PV4 | PV2 | PV3 | | | PV1 |
| 2 | PV4 | | PV3 | | PV2 | PV1 |
| 3 | PV4 | | PV3 | PV2 | | PV1 |
| 4 | PV4 | | PV3 | PV2 | PV1 | |
| 5 | PV4 | PV1 | PV3 | PV2 | | |
| 6 | PV4 | PV1 | PV3 | | PV2 | |
| 7 | PV4 | PV1 | PV3 | | | PV2 |

Im Zeitabschnitt 1 (z.B. innerhalb BP1) erfolgt das Transportieren der ersten Prozessiervorrichtung (PV1), welche in dem Prozesssockel des Endeffektors aufgenommen ist, mittels des Roboters, wenn das Beschichten des Substrats mittels der ersten Prozessiervorrichtung erfolgt. Ferner ist die zweite Prozessiervorrichtung in einem (z.B. ausgewählten) Aufbewahrungssockel (AS2) aufgenommen.

Im Zeitabschnitt 2 erfolgt die Übergabe der zweiten Prozessiervorrichtung (PV2) von dem (z.B. ausgewählten) Aufbewahrungssockel (AS2) an die Transportvorrichtung und das Transportieren der zweiten Prozessiervorrichtung (PV2) mittels der Transportvorrichtung entlang eines Transportpfads von dem Aufbewahrungssockel (AS2) zu dem Transfersockel (TS) hin (z.B. in TP2), z.B. wenn das Beschichten des Substrats mittels der ersten Prozessiervorrichtung erfolgt und/oder innerhalb BP1.

Im Zeitabschnitt 3 erfolgt die Übergabe der zweiten Prozessiervorrichtung von der Transportvorrichtung an den Transfersockel (TS), z.B. wenn das Beschichten des Substrats mittels der ersten Prozessiervorrichtung erfolgt und/oder innerhalb BP1.

Im Zeitabschnitt 4 (z.B. nach BP1) erfolgt das Transportieren der ersten Prozessiervorrichtung mittels des Roboters zu der Transferöffnung hin und die Übergabe der ersten Prozessiervorrichtung von dem Roboter (z.B. dessen Prozesssockel) an die Transportvorrichtung, z.B. wenn die zweite Prozessiervorrichtung in dem Transfersockel angeordnet und/oder wenn der Endeffektor und/oder die erste Prozessiervorrichtung in der Transferöffnung angeordnet sind.

Im Zeitabschnitt 5 erfolgt das Transportieren der ersten Prozessiervorrichtung (PV1) entlang eines Transportpfads von der Transferöffnung weg (in TP1) zu dem (z.B. ausgewählten) Aufbewahrungssockel (AS2) hin und die Übergabe der ersten Prozessiervorrichtung von der Transportvorrichtung zu dem Aufbewahrungssockel (AS2).

Im Zeitabschnitt 6 erfolgt die Übergabe der zweiten Prozessiervorrichtung von dem Transfersockel an die Transportvorrichtung und das Transportieren der zweiten Transportvorrichtung mittels der Transportvorrichtung entlang eines Transportpfads von dem Transfersockel zu der Transferöffnung.

Zum Zeitpunkt 7 erfolgt die Übergabe der zweiten Prozessiervorrichtung von der Transportvorrichtung an den Endeffektor (z.B. dessen Prozesssockel) und das Transportieren der zweiten Prozessiervorrichtung mittels des Roboters, an dem der Endeffektor montiert ist, von der Transferöffnung weg und nachfolgend das Prozessieren (z.B. Beschichten) des Substrats mittels der zweiten Prozessiervorrichtung (z.B. innerhalb BP2).

| Arbeitsbeispiel 2 ist ähnlich eingerichtet, wie Arbeitsbeispiel 1 mit dem Unterschied, dass die erste Prozessiervorrichtung in dem Transfersockel zwischengelagert wird. | AS1 | AS2 | AS3 | TS | TV | PS |
|---|---|---|---|---|---|---|
| Abschnitt | | | | | | |
| 1 | PV4 | PV2 | PV3 | | | PV1 |
| 2 | PV4 | PV2 | PV3 | | PV1 | |
| 3 | PV4 | PV2 | PV3 | PV1 | | |
| 4 | PV4 | | PV3 | PV1 | PV2 | |
| 5 | PV4 | | PV3 | PV1 | | PV2 |
| 6 | PV4 | | PV3 | | PV1 | PV2 |
| 7 | PV4 | PV1 | PV3 | | | PV2 |

| Arbeitsbeispiel 3 ist ähnlich eingerichtet, wie Arbeitsbeispiel 1 oder 2 mit dem Unterschied, dass kein Transfersockel vorhanden ist. Abschnitt | AS1 | AS2 | AS3 | AS4 | TV | PS |
|---|---|---|---|---|---|---|
| 1 | PV4 | PV2 | PV3 | | | PV1 |
| 2 | PV4 | PV2 | PV3 | | PV1 | |
| 3 | PV4 | PV2 | PV3 | PV1 | | |
| 4 | PV4 | | PV3 | PV1 | PV2 | |
| 5 | PV4 | | PV3 | PV1 | | PV2 |

Gemäß Arbeitsbeispiel 4, das vorzugsweise eingerichtet ist wie eines der Arbeitsbeispiele 1 bis 3, wird das Substrat mit einem Stapel aus mehreren Schichten (auch als Schichtsystem bezeichnet) beschichtet, wovon jede Schicht (z.B. genau) einer Prozessiervorrichtung der mehreren Prozessiervorrichtungen zugeordnet ist und mittels der Prozessiervorrichtung gebildet wird, welche der Schicht zugeordnet ist. Beispielsweise weist die Prozessiervorrichtung ein Targetmaterial (z.B. mittels eines Sputtertargets bereitgestellt) auf, welches in die Schicht eingebaut wird, die der Prozessiervorrichtung zugeordnet ist. Beispielsweise kann die Schicht aus dem Targetmaterial der Prozessiervorrichtung, welcher der Schicht zugeordnet ist, oder einem Reaktionsprodukt dessen bestehen. Beispielsweise weisen die mehreren Schichten eine Anzahl von n Schichten auf.

Gemäß Arbeitsbeispiel 5, das vorzugsweise eingerichtet ist wie eines der Arbeitsbeispiele 1 bis 4, ist das Substrat dreidimensional gekrümmt.

Gemäß Arbeitsbeispiel 6, das vorzugsweise eingerichtet ist wie eines der Arbeitsbeispiele 1 bis 5, erfolgt beim Beschichten des Substrat mittels einer Prozessiervorrichtung eine Relativbewegung zwischen dem Substrat und der Prozessiervorrichtung. Alternativ oder zusätzlich ist das Substrat beim Beschichten ortsfest angeordnet, z.B. bezüglich einer Gravitationsrichtung und/oder eines Kammergehäuses.

Gemäß Arbeitsbeispiel 7, das vorzugsweise eingerichtet ist wie eines der Arbeitsbeispiele 1 bis 6, weist der Stapel von mehreren Schichten, mit dem das Substrat beschichtet wird, eine Anzahl von n Schichten auf, die sich voneinander unterscheiden in ihrer chemischen Zusammensetzung. Alternativ oder zusätzlich weisen die mehreren Prozessiervorrichtung eine Anzahl von n Beschichtungsvorrichtungen auf, welche sich voneinander unterscheiden in ihrem Targetmaterial.

Gemäß Arbeitsbeispiel 8, das vorzugsweise eingerichtet ist wie eines der Arbeitsbeispiele 1 bis 7, wird das Substrat prozessiert, z.B. mit dem Stapel von mehreren Schichten beschichtet, in einer Prozessierkammer, in welcher das Substrat (z.B. ortsfest) angeordnet ist, während das Substrat durchgängig (ohne Unterbrechung) einem Vakuumdrucks ausgesetzt ist, der in der Prozessierkammer gebildet ist und in dem das Beschichten des Substrats erfolgt. Anschaulich wird das Substrat prozessiert (z.B. beschichtet), ohne das Vakuum in der Prozessierkammer brechen zu müssen.

Gemäß Arbeitsbeispiel 9, das vorzugsweise eingerichtet ist wie eines der Arbeitsbeispiele 1 bis 8, ist (z.B. genau) ein Roboter in der Prozessierkammer angeordnet, in der das Substrat prozessiert wird, wobei der Roboter eingerichtet ist, (z.B. genau) eine Prozessiervorrichtung zu halten. Um mehrere Schichten auf dem Substrat zu bilden, wird die von dem Roboter gehaltene Beschichtungsvorrichtung gewechselt.

Gemäß Arbeitsbeispiel 10, das vorzugsweise eingerichtet ist wie eines der Arbeitsbeispiele 1 bis 9, erfolgt der Targetwechsel (der Wechsel des Sputtertargets), indem die gesamte Prozessiervorrichtung, welche das Sputtertarget (kurz auch als Target bezeichnet) aufweist, gewechselt wird. Die Prozessiervorrichtung weist ferner das Magnetsystem und eine Kühlvorrichtung (z.B. einen Wärmetauscher und/oder eine Fluidleitung und/oder einen elektrischen Anschluss aufweisend) auf.

Gemäß Arbeitsbeispiel 11, das vorzugsweise eingerichtet ist wie eines der Arbeitsbeispiele 1 bis 10, erfolgt ein Wechsel eines (z.B. verbrauchten) Targets einer Prozessiervorrichtung, die in der Wechselkammer angeordnet ist, vollautomatisiert oder händisch. Ist die Wechselkammer als Schleusenkammer eingerichtet, kann wahlweise alternativ zum Wechsel des Targets der Prozessiervorrichtung auch die komplette Prozessiervorrichtung gewechselt werden, z.B. durch die Kammeröffnung hindurch.

Gemäß Arbeitsbeispiel 12, das vorzugsweise eingerichtet ist wie eines der Arbeitsbeispiele 1 bis 11, sind die Wechselkammer und die Prozessierkammer beim Wechsel der Prozessiervorrichtung an dem Roboter vakuumdicht voneinander separiert. Dadurch wird eine Beeinflussung der Prozessierkammer gehemmt.

Gemäß Arbeitsbeispiel 13, das vorzugsweise eingerichtet ist wie eines der Arbeitsbeispiele 1 bis 12, wird die Prozessiervorrichtung, welche ein Target und ein Magnetsystem aufweist, als Baugruppe gewechselt. Dies erleichtert es, ein an das Target angepasstes Magnetsystem für jede Prozessiervorrichtung zu verwenden.

Gemäß Arbeitsbeispiel 14, das vorzugsweise eingerichtet ist wie eines der Arbeitsbeispiele 1 bis 13, erfolgt das Ankuppeln der Prozessiervorrichtung an eine Medienversorgung in einem Grundbehälter (auch als Gestellgehäuse bezeichnet) des Roboters, dessen Inneres (auch als Anschlussraum bezeichnet) von dem Vakuum in der Prozessierkammer separiert ist. Dies hemmt eine Beeinträchtigung des Vakuums in der Prozessierkammer. Beispielsweise kann der Anschlussraum einem atmosphärischen Druck ausgesetzt sein.

Gemäß Arbeitsbeispiel 15, das vorzugsweise eingerichtet ist wie eines der Arbeitsbeispiele 1 bis 14, ist das Anschlusssystem einer Prozessiervorrichtung (z.B. deren Wasseranschluss), welche in dem Transfersockel 230 aufgenommen ist, in einem Separationsgehäuse angeordnet, dessen Inneres mittels der Prozessiervorrichtung vakuumdicht von der Transferkammer und/oder der Erdatmosphäre separiert ist. Beispielsweise kann in dem Separationsgehäuse atmosphärischer Druck und/oder diese mit atmosphärischer Luft gefüllt sein herrschen. Dies hemmt die Beeinträchtigung des Vakuums in der Prozessierkammer.

Gemäß Arbeitsbeispiel 16, das vorzugsweise eingerichtet ist wie eines der Arbeitsbeispiele 1 bis 15, ist pro Prozessierkammer und/oder Roboter genau ein Anschlussterminal und/oder genau eine Medienleitung, welche in dem Anschlussterminal mündet, vorhanden. Dies reduziert die Kosten. Die Medienleitung und/oder das Anschlussterminal können zum Austauschen elektrischer Leistung und/oder zum Austauschen eines Kühlfluids eingerichtet sein.

Gemäß Arbeitsbeispiel 17, das vorzugsweise eingerichtet ist wie eines der Arbeitsbeispiele 1 bis 16, kann die Anzahl von Aufbewahrungssockeln, und damit die Kapazität für Prozessiervorrichtungen, welche in der Wechselkammer aufgenommen werden können, beliebig gewählt werden.

Gemäß Arbeitsbeispiel 18, das vorzugsweise eingerichtet ist wie eines der Arbeitsbeispiele 1 bis 17, liegt jede Prozessiervorrichtung, welche in einem Aufbewahrungssockel aufgenommen ist, rückseitig frei und/oder einer atmosphärischen Zusammensetzung (z.B. der Erdatmosphäre) ausgesetzt. Dies erleichtert den Zugang im Fehlerfall, ohne das Vakuum in der Prozesskammer zu beeinflussen.

Gemäß Arbeitsbeispiel 19, das vorzugsweise eingerichtet ist wie eines der Arbeitsbeispiele 1 bis 18, sind die Prozessiervorrichtungen, welche in der Wechselkammer angeordnet sind, (z.B. nur) einem inerten Gas (z.B. Gasgemisch, z.B. eine Schutzatmosphäre) in der Wechselkammer ausgesetzt. Dies hemmt den Kontakt einer Prozessiervorrichtung, z.B. deren Target, mit Luft beim Wechsel.

Gemäß Arbeitsbeispiel 20, das vorzugsweise eingerichtet ist wie eines der Arbeitsbeispiele 1 bis 19, sind mehrere Verriegelungsmechanismen vorhanden, wovon ein erster Verriegelungsmechanismus eingerichtet ist, den Endeffektor mit der Transferwand zu kuppeln und/oder diese aneinander zu arretieren; und wovon pro Montagesockel (z.B. Aufbewahrungssockel und/oder Prozesssockel) ein zweiter Verriegelungsmechanismus vorhanden ist, der eingerichtet ist, die Prozessiervorrichtung, welche in dem Montagesockel aufgenommen ist, mit dem Montagesockel zu kuppeln und/oder diese aneinander zu arretieren.

Gemäß Arbeitsbeispiel 21, das vorzugsweise eingerichtet ist wie eines der Arbeitsbeispiele 1 bis 20, ist für den ersten Verriegelungsmechanismus und/oder für den zweiten Verriegelungsmechanismus eine Betätigungsvorrichtung vorhanden, welche eingerichtet ist, den Verriegelungsmechanismus in einen ersten Zustand oder einen zweiten Zustand zu bringen. Der erste Verriegelungsmechanismus kann, in den ersten Zustand gebracht, eine Bewegung zwischen dem Endeffektor und der Transferwand blockieren und/oder diese aneinander zu arretieren, und in den zweiten Zustand gebracht, die Bewegung freigeben und/oder die Arretierung aufheben. Der zweite Verriegelungsmechanismus kann, in den ersten Zustand gebracht, eine Bewegung zwischen der Prozessiervorrichtung und dem Montagesockel blockieren und/oder diese aneinander zu arretieren, und in den zweiten Zustand gebracht, die Bewegung freigeben und/oder die Arretierung aufheben.

Gemäß Arbeitsbeispiel 22, das vorzugsweise eingerichtet ist wie eines der Arbeitsbeispiele 1 bis 21, weist jede Prozessiervorrichtung einen (z.B. mechanischen und/oder geometrischen) Identifikator auf, wobei jeder der Aufbewahrungssockel einem oder mehr als einem Identifikator zugeordnet und eingerichtet ist, nur diejenige Prozessiervorrichtung, welche den Identifikator, der dem Aufbewahrungssockel zugeordnet ist, aufzunehmen. Die hemmt eine Verwechslung, insbesondere wenn die Prozessiervorrichtungen händisch gewartet werden.

Gemäß Arbeitsbeispiel 23, das vorzugsweise eingerichtet ist wie eines der Arbeitsbeispiele 1 bis 22, weist das Verfahren Folgendes auf:
- Der Endeffektor (z.B. dessen Trägergehäuse), in welchem eine erste Prozessiervorrichtung (z.B. Quelle 1) aufgenommen ist, wird in Kontakt gebracht mit der Transferwand (z.B. deren Schleusenplanfläche), wenn die erste Prozessiervorrichtung in der Transferöffnung hinein bewegt wird.
- Nachfolgend wird der zweite Verriegelungsmechanismus mittels der Transfer-Betätigungsvorrichtung (z.B. Mechanik 1) betätigt, welche den Endeffektor vakuumdicht mit der Transferwand kuppelt (und z.B. dessen Verriegelungsdorn arretiert).
- Nachfolgend wird die Wechselkammer (z.B. Schleusenkammer) belüftet, z.B. mit einem inerten Gas (z.B. Schutzgas) und/oder bis auf atmosphärischen Druck.
- Nachfolgend schwenkt die Transportvorrichtung ihren Greifer (z.B. Aktuator) in eine Aufnahmenut 854 (auch als Aufnahme bezeichnet) der ersten Prozessiervorrichtung (z.B. Quelle 1) hinein, wenn die erste Prozessiervorrichtung von dem Endeffektor aufgenommen ist.
- Nachfolgend schwenkt die Sockel-Betätigungsvorrichtung in den Sockel-Verrieglungsmechanismus hinein, welche die erste Prozessiervorrichtung (z.B. Quelle 1) mit dem Endeffektor arretiert, ein bringt diese in den unverriegelten Zustand, was die erste Prozessiervorrichtung löst.
- Nachfolgend hebt die Transportvorrichtung (z.B. deren Aktuator) die erste Prozessiervorrichtung von dem Endeffektor ab. Dabei wird das Anschlusssystem der ersten Prozessiervorrichtung von dem Endeffektor (z.B. dessen Anschlussterminal) gelöst, so dass die Medienleitungen voneinander getrennt werden.
- Nachfolgend setzt die Transportvorrichtung (z.B. deren Aktuator) die erste Prozessiervorrichtung in dem Transfersockel (anschaulich eine Zwischenablageposition bereitstellend) ab. Der Transfersockel ist rückseitig von der Erdatmosphäre separiert.
- Nachfolgend schwenkt die Transportvorrichtung (z.B. deren Aktuator) in die Aufnahmenut 854 (auch als Aufnahme bezeichnet) der zweiten Prozessiervorrichtung ein, welche in einem Aufbewahrungssockel aufgenommen ist.
- Nachfolgend schwenkt die Sockel-Betätigungsvorrichtung in den Sockel-Verrieglungsmechanismus, welcher die zweite Prozessiervorrichtung (z.B. Quelle 2) mit dem Aufbewahrungssockel arretiert, ein und bringt diese in den unverriegelten Zustand, was die zweite Prozessiervorrichtung löst.
- Nachfolgend hebt die Transportvorrichtung (z.B. deren Aktuator) die zweite Prozessiervorrichtung (z.B. Quelle 2) von dem Aufbewahrungssockel ab und setzt diese in den Endeffektor (z.B. dessen Prozesssockel) ein;
- Nachfolgend wird der Sockel-Verriegelungsmechanismus des Endeffektors mittels der Sockel-Betätigungsvorrichtung in den arretierenden Zustand gebracht, so dass die zweite Prozessiervorrichtung an dem Endeffektor arretiert ist.
- Nachfolgend schwenk die Transportvorrichtung (z.B. deren Aktuator) in die Aufnahmenut der ersten Prozessiervorrichtung, welche in dem Transfersockel aufgenommen ist (und sich anschaulich in der Zwischenablageposition befindet).
- Nachfolgend transportiert die Transportvorrichtung (z.B. deren Aktuator) die erste Prozessiervorrichtung in den freiliegenden Aufbewahrungssockel, welcher rückseitig der Erdatmosphäre ausgesetzt ist.
- Nachfolgend schwenkt die Sockel-Betätigungsvorrichtung in den Sockel-Verrieglungsmechanismus des Aufbewahrungssockels ein und bringt diese in den arretierenden Zustand, was die erste Prozessiervorrichtung mit dem Kammergehäuse arretiert.
- Nachfolgend wird die Wechselkammer (z.B. Schleusenkammer) evakuiert (abgepumpt), z.B. auf das Druckniveau der Prozessierkammer gebracht.
- Nachfolgend wird der Endeffektor-Verriegelungsmechanismus, z.B. mittels der Transfer-Betätigungsvorrichtung (z.B. eine Drehverriegelung), in den unarretierenden Zustand gebracht, was die Arretierung des Endeffektors an dem Kammergehäuse aufhebt.
- Nachfolgend wird der Endeffektor von der Wechselkammer (auch als Transferkammer bezeichnet) weg transportiert, z.B. mittels des Roboters.

## Patentansprüche

1. Prozessiervorrichtung-Wechselsystem, aufweisend:
• ein Kammergehäuse (502), welches eine Vakuumkammer bereitstellt und eine darin mündende Transferöffnung (120) aufweist;
• mehrere in der Vakuumkammer bereitgestellte erste Lagersockel (130), wovon jeder erste Lagersockel (130) eingerichtet ist, eine Prozessiervorrichtung formschlüssig aufzunehmen;
• eine Transportvorrichtung, welche eingerichtet ist, für jeden der ersten Lagersockel (130) einen Transportpfad zwischen dem ersten Lagersockel (130) und der Transferöffnung (120) bereitzustellen zum Transportieren der Prozessiervorrichtung entlang des Transportpfads.

2. Prozessiervorrichtung-Wechselsystem gemäß Anspruch 1, ferner aufweisend:
• einen Endeffektor, welcher eingerichtet ist, in der Transferöffnung (120) aufgenommen zu werden und einen zweiten Lagersockel (536) aufweist, der eingerichtet ist, die Prozessiervorrichtung aufzunehmen;
• wobei der Endeffektor vorzugsweise ein Anschlusssystem aufweist, das eingerichtet ist, mit der Prozessiervorrichtung gekuppelt zu werden, wenn die Prozessiervorrichtung in dem zweiten Lagersockel (536) aufgenommen wird.

3. Prozessiervorrichtung-Wechselsystem gemäß einem der Ansprüche 1 bis 2, ferner aufweisend:
ein Arretierungsmechanismus, welcher eingerichtet ist, den in der Transferöffnung (120) aufgenommen Endeffektor und das Kammergehäuse (502) miteinander zu arretieren.

4. Prozessiervorrichtung-Wechselsystem gemäß einem der Ansprüche 1 bis 3, ferner aufweisend:
• einen dritten Lagersockel (230), welcher in der Vakuumkammer bereitgestellt und eingerichtet ist, die Prozessiervorrichtung aufzunehmen;
• wobei die Transportvorrichtung eingerichtet ist, für jeden der ersten Lagersockel (130) einen zusätzlichen Transportpfad zwischen dem ersten Lagersockel (130) und dem dritten Lagersockel (230) und zwischen der Transferöffnung (120) und dem dritten Lagersockel (230) bereitzustellen zum Transportieren der Prozessiervorrichtung entlang des zusätzlichen Transportpfads.

5. Prozessiervorrichtung-Wechselsystem gemäß einem der Ansprüche 1 bis 4, wobei das Kammergehäuse eine Kammerwand aufweist, welche mit jedem der ersten Lagersockel gekuppelt ist, und welche von mehreren Durchgangsöffnungen durchdrungen ist, wovon jede Durchgangsöffnung einen Aufnahmeraum jedes der ersten Lagersockel bereitstellt oder darin mündet.

6. Prozessiervorrichtung-Wechselsystem gemäß einem der Ansprüche 1 bis 5, wobei jeder der ersten Lagersockel eine Dichtvorrichtung aufweist zum vakuumdichten Aufnehmen der Prozessiervorrichtung.

7. Prozessiervorrichtung-Wechselsystem gemäß Anspruch 6, wobei jeder der ersten Lagersockel eine Montagevorrichtung zum Montieren der Prozessiervorrichtung aufweist, welche eingerichtet ist, die Prozessiervorrichtung gegen die Dichtvorrichtung zu pressen.

8. Prozessiervorrichtung-Wechselsystem gemäß Anspruch 7, wobei jeder der ersten Lagersockel einen Hohlraum und Anschlusssystem aufweist, das in dem Hohlraum eingerichtet und eingerichtet ist, mit der Prozessiervorrichtung gekuppelt zu werden, wenn die Prozessiervorrichtung in dem Lagersockel aufgenommen wird.

9. Prozessiervorrichtung-Wechselsystem gemäß einem der Ansprüche 1 bis 8, wobei die Transportvorrichtung eingerichtet ist, die Prozessiervorrichtung in jeden der ersten Lagersockel hineinzustecken.

10. Prozessiervorrichtung-Wechselsystem gemäß einem der Ansprüche 1 bis 9, ferner die Prozessiervorrichtung aufweisend, welche ein Magnetsystem und eine Lagervorrichtung zum Lagern eines Sputtertargets aufweist.

11. Verfahren zum Ansteuern einer Transportvorrichtung des Prozessiervorrichtung-Wechselsystems gemäß einem der Ansprüche 1 bis 10 gemäß einer Transportsequenz, wobei die Transportsequenz aufweist:
• eine erste Phase, in welcher eine erste Prozessiervorrichtung mittels der Transportvorrichtung von der Transferöffnung (120) weg transportiert wird;
• eine zweite Phase, in welcher eine zweite Prozessiervorrichtung mittels der Transportvorrichtung zu der Transferöffnung (120) hin transportiert wird;
• wobei die erste Prozessiervorrichtung dem ersten Lagersockel hin transportiert wird, von welchem die zweite Prozessiervorrichtung weg transportiert.

12. Steuervorrichtung, welche einen oder mehr als einen Prozessor aufweist, der eingerichtet ist, zum Durchführen des Verfahrens gemäß Anspruch 11.

13. computerlesbares Medium, das Instruktionen speichert, die eingerichtet sind, wenn von einem Prozessor ausgeführt, den Prozessor dazu zu bringen, das Verfahren gemäß Anspruch 11 durchzuführen.

14. Computerprogramm, eingerichtet ist, wenn von einem Prozessor ausgeführt, den Prozessor dazu zu bringen, das Verfahren gemäß Anspruch 11 durchzuführen.

15. Vakuumanordnung, aufweisend:
• ein Prozessiervorrichtung-Wechselsystem gemäß einem der Ansprüche 1 bis 10;
• eine Prozessierkammer, in welcher die Transferöffnung (120) mündet;
• eine Substrathaltevorrichtung zum Halten eines Substrats in der Prozessierkammer;
• einen Roboter, welcher eingerichtet ist, die Prozessiervorrichtung (150) mittels der Transferöffnung (120) an die Transportvorrichtung zu übergeben und/oder von dieser übergeben zu bekommen, und eingerichtet ist, die Prozessiervorrichtung in der Prozessierkammer zu bewegen.
